# EUROPEAN PATENT APPLICATION

(11) **EP 4 510 804 A1**
(43) Date of publication of application: **19.02.2025**
(21) Application number: 24192706.0
(22) Date of filing: 02.08.2024
(51) Int. Cl.: H10D 1/20

(54) **INTEGRATED CIRCUIT DEVICE INCLUDING A DIODE**

(30) Priority: 08.08.2023 KR 20230103698
(71) Applicant: Samsung Electronics Co., Ltd, Suwon-si, Gyeonggi-do 16677 (KR)
(72) Inventor: KANG, Duckseoung, 16677 Suwon-si (KR); KWON, Sangdeok, 16677 Suwon-si (KR); KIM, Gibum, 16677 Suwon-si (KR); LEE, Seungjae, 16677 Suwon-si (KR)
(74) Representative: Marks & Clerk LLP

(57) **Abstract**

An integrated circuit device includes: a substrate including a first surface and a second surface that is opposite to the first surface; and a diode structure including: an upper semiconductor layer disposed on the first surface of the substrate and including a first dopant of a first conductivity type; a lower semiconductor layer disposed on the second surface of the substrate and including a second dopant of a second conductivity type that is different from the first conductivity type; and a first well region provided in a portion of the substrate that is between the upper semiconductor layer and the lower semiconductor layer, wherein the first well region is in contact with the upper semiconductor layer or the lower semiconductor layer.

## Description

### TECHNICAL FIELD

Embodiments of the present inventive concept relate to an integrated circuit device, and more particularly, to an integrated circuit device including a diode.

### DISCUSSION OF THE RELATED ART

Due to the continuous development of electronics technology, the demand for high integration of integrated circuit devices is increasing and downscaling has been continuously progressing. With the downscaling of integrated circuit devices, the desirability of electrostatic discharge (ESD) protection within integrated circuit devices is increasing. Conventional ESD protection elements include diodes that are connected between a power/ground connection unit and an integrated circuit pin connection unit. However, in three-dimensional integrated circuit devices such as finFET or nanosheet FET, the thickness and/or volume of silicon substrates decreases, which may make it difficult to form an efficient p-n junction.

### SUMMARY

According to embodiments of the present inventive concept, an integrated circuit device comprises: a substrate comprising a first surface and a second surface that is opposite to the first surface; and a diode structure comprising: an upper semiconductor layer disposed on the first surface of the substrate and including a first dopant of a first conductivity type; a lower semiconductor layer disposed on the second surface of the substrate and including a second dopant of a second conductivity type that is different from the first conductivity type; and a first well region provided in a portion of the substrate that is between the upper semiconductor layer and the lower semiconductor layer, wherein the first well region is in contact with the upper semiconductor layer or the lower semiconductor layer.

According to embodiments of the present inventive concept, an integrated circuit device comprises: a diode structure, wherein the diode structure comprises: an upper semiconductor layer disposed on a first surface of a substrate and including a first dopant of a first conductivity type; a lower semiconductor layer disposed on a second surface of the substrate that is opposite to the first surface of the substrate and including a second dopant of a second conductivity type that is different from the first conductivity type; a first well region arranged in a first portion of the substrate and including a third dopant of the first conductivity type, wherein the first portion is adjacent to the first surface of the substrate; and a second well region arranged in a second portion of the substrate and including a fourth dopant of the second conductivity type, wherein the second portion is adjacent to the second surface of the substrate.

According to embodiments of the present inventive concept, an integrated circuit device comprises: a diode structure, wherein the diode structure comprises: an upper semiconductor layer disposed on a first surface of a substrate and including a first dopant of a first conductivity type; a lower semiconductor layer disposed on a second surface of the substrate that is opposite to the first surface of the substrate and including a second dopant of a second conductivity type that is different from the first conductivity type; a first well region arranged in a first portion of the substrate and including a third dopant of the first conductivity type, wherein the first portion of the substrate is adjacent to the first surface of the substrate; and a second well region arranged in a second portion of the substrate and including a fourth dopant of the second conductivity type, wherein the second portion of the substrate is adjacent to the second surface of the substrate; a nanosheet structure disposed on the first surface of the substrate and arranged adjacent to a sidewall of the upper semiconductor layer; a first contact disposed on a first surface of the upper semiconductor layer; a front-surface wiring structure electrically connected to the first contact; a mold insulating layer disposed on the second surface of the substrate and the lower semiconductor layer; a second contact disposed on a first surface of the lower semiconductor layer; and a rear-surface wiring structure electrically connected to the second contact.

At least some of the above and other features of the disclosure are set out in the claims.

### BRIEF DESCRIPTION OF THE DRAWINGS

The above and other aspects of the present inventive concept will become more apparent by describing in detail embodiments thereof, with reference to the accompanying drawings, in which:
FIG. 1 is a schematic layout of an integrated circuit device according to embodiments of the present inventive concept;
FIG. 2 is a cross-sectional view of the integrated circuit device of FIG. 1 taken along line A1-A1' of FIG. 1;
FIG. 3 is a cross-sectional view of the integrated circuit device of FIG. 1 taken along line A2-A2' of FIG. 1;
FIG. 4 is a cross-sectional view of an integrated circuit device according to embodiments of the present inventive concept;
FIG. 5 is a cross-sectional view of an integrated circuit device according to embodiments of the present inventive concept;
FIG. 6 is a cross-sectional view of an integrated circuit device according to embodiments of the present inventive concept;
FIG. 7 is a cross-sectional view of an integrated circuit device according to embodiments of the present inventive concept;
FIG. 8 is a cross-sectional view of an integrated circuit device according to embodiments of the present inventive concept;
FIG. 9 is a cross-sectional view of an integrated circuit device according to embodiments of the present inventive concept;
FIG. 10 is a cross-sectional view of an integrated circuit device according to embodiments of the present inventive concept;
FIG. 11 is a cross-sectional view of an integrated circuit device according to embodiments of the present inventive concept;
FIG. 12 is a layout of an integrated circuit device according to embodiments of the present inventive concept;
FIG. 13 is a cross-sectional view of the integrated circuit device of FIG 12 taken along line A1-A1' of FIG. 12;
FIG. 14 is a cross-sectional view of the integrated circuit device of FIG. 12 taken along the line A2-A2' of FIG. 12;
FIGS. 15 and 16 are cross-sectional views of an integrated circuit device according to embodiments; and
FIGS. 17, 18, 19, 20, 21, 22, 23, 24, 25, 26, 27, 28, 29, 30, 31, and 32 are cross-sectional views of a method of manufacturing an integrated circuit device, according to embodiments of the present inventive concept.

### DETAILED DESCRIPTION OF THE EMBODIMENTS

Embodiments of the present inventive concept will now be described fully with reference to the accompanying drawings. In the description below, the terms vertical direction, first horizontal direction, and second horizontal direction are used to refer to the Z direction, X direction, and Y direction, respectively. However, one of skill in the art will appreciate these may be varied. For example, the first horizontal direction may refer to the Y direction, while the second horizontal direction refers to the X direction. Thus, a width, for example, may be in a first or a second horizontal direction as will be described.

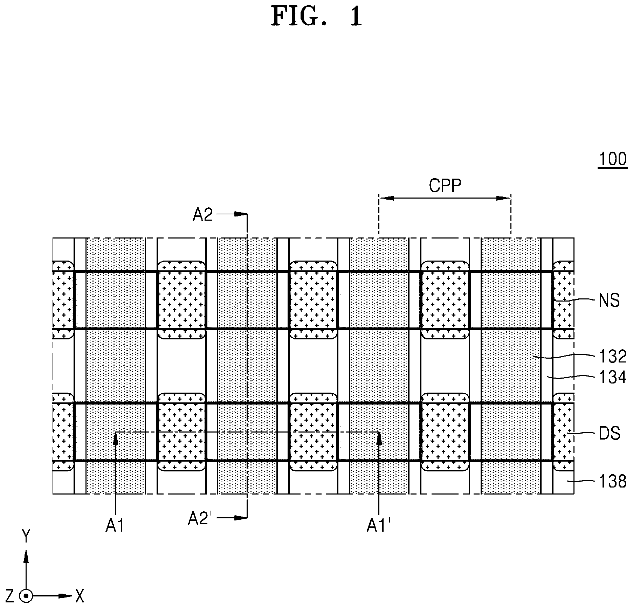

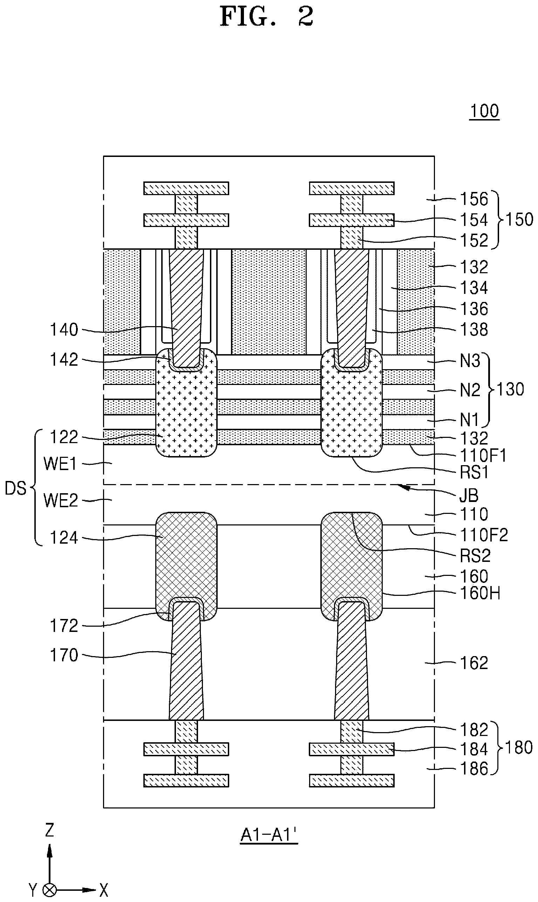

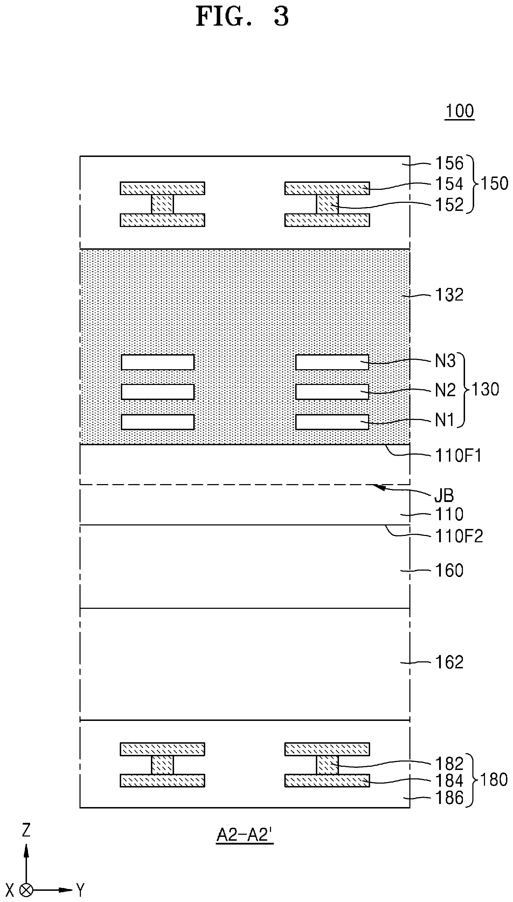

FIG. 1 is a schematic layout of an integrated circuit device 100 according to embodiments of the present inventive concept. FIG. 2 is a cross-sectional view of the integrated circuit device 100 of FIG. 1 taken along line A1-A1' of FIG. 1. FIG. 3 is a cross-sectional view of the integrated circuit device 100 of FIG. 1 taken along line A2-A2' of FIG. 1.

Referring to FIGS. 1 to 3, the integrated circuit device 100 may include a diode structure DS formed on a substrate 110. The integrated circuit device 100 may further include a field effect transistor that is formed on the substrate 110, and at least a portion of the diode structure DS may be formed simultaneously in a process of manufacturing the field effect transistor. In embodiments of the present inventive concept, the field effect transistor may include a logic cell including a multi-bridge channel FET (MBCFET) element. The diode structure DS may be a portion of an electrostatic discharge (ESD) protection circuit electrically connected to the logic cell.

In embodiments of the present inventive concept, the substrate 110 may include a Group IV semiconductor such as Si or Ge, a Group IV-IV compound semiconductor such as SiGe or SiC, or a Group III-V compound semiconductor such as GaAs, InAs, or InP. The substrate 110 may include a first surface 110F1 and a second surface 110F2 opposite to the first surface 110F1.

The diode structure DS may include an upper semiconductor layer 122, a lower semiconductor layer 124, a first well region WE1, and a second well region WE2. The upper semiconductor layer 122, the lower semiconductor layer 124, the first well region WE1, and the second well region WE2 may be arranged to overlap (or overlay) each other in a vertical direction Z, and the diode structure DS may include a vertical diode having a current path formed in the vertical direction Z.

The upper semiconductor layer 122 may be disposed on the first surface 110F1 of the substrate 110. The bottom of the upper semiconductor layer 122 may be arranged in a first recess region RS1 that is formed in the first surface 110F1 of the substrate 110 and may extend upward (or, for example, a direction away) from the first surface 110F1 of the substrate 110. For example, the first recess region RS1 may refer to a portion of the substrate 110, the portion being recessed in a direction from the first surface 110F1 of the substrate 110 toward the second surface 110F2 of the substrate 110, and the upper semiconductor layer 122 may extend in the vertical direction Z from above the first recess region RS1 in a direction away from the second surface 110F2 of the substrate 110 (or in a direction away from the substrate 110).

In embodiments of the present inventive concept, the upper semiconductor layer 122 may include at least one semiconductor material such as Si, SiGe, SiP, SiGeB, and SiGeC. In embodiments of the present inventive concept, the upper semiconductor layer 122 may be formed on the first surface 110F1 of the substrate 110 via an epitaxial growth process by using an exposed surface of the first recess region RS1 as a seed layer.

In embodiments of the present inventive concept, the upper semiconductor layer 122 may include a first dopant of a first conductivity type, and for example, the first conductivity type may be n type. For example, the first dopant may include phosphorus or arsenic. The upper semiconductor layer 122 may be a region including a relatively high concentration of the first dopant, and for example, may be referred to as an N+ region.

The lower semiconductor layer 124 may be disposed on the second surface 110F2 of the substrate 110. The lower semiconductor layer 124 may be arranged in a second recess region RS2 that is formed in the second surface 110F2 of the substrate 110 and may extend downward from the second surface 110F2 of the substrate 110. For example, the lower semiconductor layer 124 may extend away from the substrate 110. For example, the second recess region RS2 may refer to a portion of the substrate 110, the portion being recessed in a direction from the second surface 110F2 of the substrate 110 toward the first surface 110F1 of the substrate 110. For example, an upper surface of the lower semiconductor layer 124 may be in contact with the second recess region RS2, and the lower semiconductor layer 124 may extend in the vertical direction Z in a direction away from the first surface 110F1 of the substrate 110 (or in a direction away from the substrate 110). For example, as shown in FIG. 2, the upper semiconductor layer 122 and the lower semiconductor layer 124 may vertically overlap (or overlay) each other, and the substrate 110 may be arranged between the upper semiconductor layer 122 and the lower semiconductor layer 124. However, the present inventive concept is not limited thereto. For example, the upper semiconductor layer 122 might not overlap (or overlay) the lower semiconductor layer 124.

In embodiments of the present inventive concept, the lower semiconductor layer 124 may include at least one of Si, SiGe, SiP, SiGeB, and SiGeC. In embodiments of the present inventive concept, the lower semiconductor layer 124 may be formed on the second surface 110F2 of the substrate 110 via an epitaxial growth process by using an exposed surface of the second recess region RS2 as a seed layer.

In embodiments of the present inventive concept, the lower semiconductor layer 124 may include a second dopant of a second conductivity type, and the second conductivity type may be different from the first conductivity type. For example, the second conductivity type may be p type. For example, the second dopant may include boron. The lower semiconductor layer 124 may be a region including a relatively high concentration of the second dopant, and for example, may be referred to as a P+ region.

The first well region WE1 may be disposed in an upper side of the substrate 110, the upper side being adjacent to the first surface 110F1 of the substrate 110, or may be arranged in a first portion of the substrate 110. In addition, the first well region WE1 may be arranged between the upper semiconductor layer 122 and the lower semiconductor layer 124 in the vertical direction Z. The first well region WE1 may be in contact with the upper semiconductor layer 122.

In embodiments of the present inventive concept, the first well region WE1 may include a third dopant of the first conductivity type. For example, the first well region WE1 may be an impurity region formed by ion planting the third dopant into the first portion of the substrate 110, the first portion being adjacent to the first surface 110F1 of the substrate 110. For example, the third dopant may include phosphorus or arsenic.

The second well region WE2 may be disposed in a lower side of the substrate 110, the lower side being adjacent to the second surface 110F2 of the substrate 110, or may be arranged in a second portion of the substrate 110. The second well region WE2 may be arranged between the upper semiconductor layer 122 and the lower semiconductor layer 124 in the vertical direction Z. The second well region WE2 may be in contact with the lower semiconductor layer 124.

In embodiments of the present inventive concept, the second well region WE2 may include a fourth dopant of the second conductivity type. For example, the second well region WE2 may be an impurity region formed by ion planting the fourth dopant into the second portion of the substrate 110, the second portion being adjacent to the second surface 110F2 of the substrate 110. For example, the fourth dopant may include boron.

As shown in FIG. 2, the first well region WE1 may be disposed in the upper side of the substrate 110, and the second well region WE2 may be disposed in the lower side of the substrate 110 to vertically overlap (or overlay) the first well region WE1. The first well region WE1 and the second well region WE2 may form a p-n junction. As the first well region WE1 and the second well region WE2 are arranged adjacent to each other in the substrate 110 in the vertical direction Z, the p-n junction having a relatively large area may be obtained.

In FIG. 2, a junction boundary JB between the first well region WE1 and the second well region WE2 is schematically shown as a dotted line. FIG. 2 shows that the junction boundary JB between the first well region WE1 and the second well region WE2 has a flat profile over the entire width of the first well region WE1 and the second well region WE2. However, due to conditions of an ion plantation process for forming the first well region WE1 and the second well region WE2, or tolerances occurring in the ion plantation process, the junction boundary JB may have a profile that is different from that shown in FIG. 2, such as having a curved profile or a wavy profile.

A nanosheet structure 130 may be disposed on the first surface 110F1 of the substrate 110. The nanosheet structure 130 may include at least two nanosheets overlapping (or overlaying) each other on the first surface 110F1 of the substrate 110 in the vertical direction Z. For example, FIG. 2 illustrates that the nanosheet structure 130 includes a first nanosheet N1, a second nanosheet N2, and a third nanosheet N3, but the number of nanosheets is not limited thereto and may vary.

In embodiments of the present inventive concept, the nanosheet structure 130 may include a Group IV semiconductor such as Si or Ge, a Group IV-IV compound semiconductor such as SiGe or SiC, or a Group III-V compound semiconductor such as GaAs, InAs, or InP. The first nanosheet N1, the second nanosheet N2, and the third nanosheet N3 may each have a relatively large width in a first horizontal direction X and a second horizontal direction Y and a relatively small width in the vertical direction Z, and for example, may each have a nanosheet shape.

In embodiments of the present inventive concept, the first nanosheet N1, the second nanosheet N2, and the third nanosheet N3 may each have a width of about 5 nm to about 100 nm in the second horizontal direction Y, and the first nanosheet N1, the second nanosheet N2, and the third nanosheet N3 may each have a thickness of about 1 nm to about 10 nm in the vertical direction Z, but the present inventive concept is not limited thereto.

A cover insulating line 132 may be arranged to surround the nanosheet structure 130. For example, the cover insulating line 132 may be arranged between the first nanosheet N1 and the first surface 110F1 of the substrate 110, between the first nanosheet N1 and the second nanosheet N2, and between the second nanosheet N2 and the third nanosheet N3, and may be disposed on an upper surface of the third nanosheet N3. The cover insulating line 132 may include, for example, silicon oxide (SiOₓ), silicon nitride (SiNₓ), silicon oxynitride (SiOₓN_{y}), silicon carbonitride (SiCₓN_{y}), silicon oxycarbonitride (SiOₓC_{y}N_{z}), or a combination thereof.

The nanosheet structure 130 and the cover insulating line 132 may be arranged adjacent to a sidewall of the upper semiconductor layer 122. For example, the upper semiconductor layer 122 may have an upper surface arranged at a level that is higher than the upper surface of the third nanosheet N3, and for example, the sidewall of the upper semiconductor layer 122 may be at least partially surrounded by the first nanosheet N1, the second nanosheet N2, the third nanosheet N3, and the cover insulating line 132.

A pair of spacers 134 may be disposed on the nanosheet structure 130. The pair of spacers 134 may be disposed on a sidewall of the cover insulating line 132 disposed on the upper surface of the third nanosheet N3 and may extend in the second horizontal direction Y. The pair of spacers 134 may include, for example, silicon oxide (SiOₓ), silicon nitride (SiNₓ), silicon oxynitride (SiOₓN_{y}), silicon carbonitride (SiCₓN_{y}), silicon oxycarbonitride (SiOₓC_{y}N_{z}), or a combination thereof.

In embodiments of the present inventive concept, the nanosheet structure 130 may be formed simultaneously in a manufacturing process for forming a nanosheet structure included in an MBCFET element that may be formed on another portion of the substrate 110. In addition, the pair of spacers 134 may be formed simultaneously in a manufacturing process for forming spacers that are disposed on both sides of a gate line included in the MBCFET element. In addition, the upper semiconductor layer 122 may be formed simultaneously in a manufacturing process for forming source/drain regions disposed on both sides of the gate line included in the MBCFET element.

In embodiments of the present inventive concept, as shown in FIG. 1, a plurality of pairs of spacers 134 may be arranged apart from each other at a reference interval CPP, or a plurality of cover insulating lines 132 may be arranged apart from each other at the reference interval CPP. In this regard, the reference interval CPP may be the same as a gate interval of the gate line included in the MBCFET element.

An etch stop film 136 may be disposed on a wall of each of the pair of spacers 134 to conformally cover an upper surface of the upper semiconductor layer 122. For example, the etch stop film 136 may be disposed on an outer wall of each of the pair of spacers 134. A first buried insulating layer 138 may be disposed on the etch stop film 136.

As shown in FIG. 1, the first buried insulating layer 138 may have a layout of a line pattern that fills a space between two upper semiconductor layers 122 arranged adjacent to each other in the second horizontal direction Y and that extends in the second horizontal direction Y. For example, the first buried insulating layer 138 may be arranged between two cover insulating lines 132 extending in the second horizontal direction Y and arranged adjacent to each other in the first horizontal direction X.

In embodiments of the present inventive concept, the etch stop film 136 may include silicon carbide (SiC), SiN, nitrogen-doped silicon carbide (SiC:N), SiOC, AlN, AlON, AlO, AlOC, or a combination thereof. The first buried insulating layer 138 may include, for example, a tetraethyl orthosilicate (TEOS) film, a high density plasma (HDP) oxide film, a boro-phosphosilicate glass (BPSG) film, a flowable chemical vapor deposition (FCVD) oxide film, a SiON film, a SiN film, a SiOC film, a SiCOH film, or a combination thereof, but the present inventive concept is not limited thereto.

A first contact 140 may be connected to the upper semiconductor layer 122 through the first buried insulating layer 138 and the etch stop film 136. For example, the first contact 140 may be disposed on an upper surface or first surface of the upper semiconductor layer 122. A metal silicide film 142 may be arranged between the first contact 140 and the upper semiconductor layer 122. In embodiments of the present inventive concept, the metal silicide film 142 may be omitted, and the first contact 140 and the upper semiconductor layer 122 may be in direct contact with each other.

In embodiments of the present inventive concept, the first contact 140 may include a conductive barrier pattern and a contact plug, and the conductive barrier pattern may at least partially surround a bottom surface and sidewall of a contact plug and may be in contact with the bottom surface and sidewall of the contact plug. In embodiments of the present inventive concept, the conductive barrier pattern may include metal or metal nitride. For example, the conductive barrier pattern may include Ti, Ta, W, TiN, TaN, WN, WCN, TiSiN, TaSiN, WSiN, or a combination thereof, but the present inventive concept is not limited thereto. The contact plug may include molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but the present inventive concept is not limited thereto. The metal silicide film 142 may include tungsten silicide, nickel silicide, or cobalt silicide.

A front-surface wiring structure 150 may be disposed on the first buried insulating layer 138. The front-surface wiring structure 150 may include a front-surface via 152, a front-surface wiring layer 154, and a front-surface interlayer insulating film 156. For example, the front-surface wiring layer 154 may be disposed at a plurality of levels in the vertical direction Z, and the front-surface via 152 may be connected between front-surface wiring layers 154 that are arranged at different vertical levels. The front-surface via 152 may be disposed on the first contact 140, and the first contact 140 may be connected to the front-surface wiring layer 154 via the front-surface via 152. A portion of the front-surface wiring layer 154 may have a pad shape to apply a power voltage or a ground voltage to the diode structure DS. Accordingly, the power voltage or the ground voltage may be applied to the diode structure DS via the portion of the front-surface wiring layer 154, and a current path may be formed in the diode structure DS in the vertical direction Z.

A mold insulating layer 160 may be disposed on the second surface 110F2 of the substrate 110. The mold insulating layer 160 may be arranged on the second surface 110F2 of the substrate 110 and may at least partially surround a sidewall of the lower semiconductor layer 124. For example, the mold insulating layer 160 may include an opening 160H, and the lower semiconductor layer 124 may be arranged in the opening 160H. The lower semiconductor layer 124 may protrude downward from a bottom surface of the mold insulating layer 160 (in this regard, a surface of the mold insulating layer 160, which is in contact with the second surface 110F2 of the substrate 110, is referred to as an upper surface of the mold insulating layer 160, and a surface opposite to the upper surface of the mold insulating layer 160 is referred to as the bottom surface of the mold insulating layer 160). The lower semiconductor layer 124 may have a height greater than the height of the mold insulating layer 160 in the vertical direction Z, and accordingly, a bottom surface or first surface of the lower semiconductor layer 124 may protrude downward with respect to the bottom surface of the mold insulating layer 160. For example, the bottom surface of the lower semiconductor layer 124 may be lower than the bottom surface of the mold insulating layer 160.

In embodiments of the present inventive concept, the mold insulating layer 160 may include a TEOS film, an HDP oxide film, a BPSG film, an FCVD oxide film, a SiON film, a SiN film, a SiOC film, a SiCOH film, or a combination thereof, but the present inventive concept is not limited thereto.

A second buried insulating layer 162 may be disposed on the bottom surface of the mold insulating layer 160. The second buried insulating layer 162 may be arranged on the bottom surface of the mold insulating layer 160 to cover the bottom surface or first surface of the lower semiconductor layer 124. For example, the mold insulating layer 160 and the second buried insulating layer 162 may be sequentially disposed on the second surface 110F2 of the substrate 110, and may be arranged at a vertical level that is lower than that of the second surface 110F2 of the substrate 110.

In embodiments of the present inventive concept, the second buried insulating layer 162 may include a TEOS film, an HDP oxide film, a BPSG film, an FCVD oxide film, a SiON film, a SiN film, a SiOC film, a SiCOH film, or a combination thereof, but the present inventive concept is not limited thereto.

A second contact 170 may be connected to the lower semiconductor layer 124 through the second buried insulating layer 162. A metal silicide film 172 may be arranged between the second contact 170 and the lower semiconductor layer 124. In embodiments of the present inventive concept, the metal silicide film 172 may be omitted, and the second contact 170 and the lower semiconductor layer 124 may be in direct contact with each other.

In embodiments of the present inventive concept, the second contact 170 may include a conductive barrier pattern and a contact plug, and the conductive barrier pattern may at least partially surround a bottom surface and sidewall of a contact plug and may be in contact with the bottom surface and sidewall of the contact plug. In embodiments of the present inventive concept, the conductive barrier pattern may include metal or metal nitride. For example, the conductive barrier pattern may include Ti, Ta, W, TiN, TaN, WN, WCN, TiSiN, TaSiN, WSiN, or a combination thereof, but the present inventive concept is not limited thereto. The contact plug may include, for example, molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but the present inventive concept is not limited thereto. The metal silicide film 172 may include, for example, tungsten silicide, nickel silicide, or cobalt silicide.

A rear-surface wiring structure 180 may be disposed on a bottom surface of the second buried insulating layer 162. The rear-surface wiring structure 180 may include a rear-surface via 182, a rear-surface wiring layer 184, and a rear-surface interlayer insulating film 186. For example, the rear-surface wiring layer 184 may be disposed at a plurality of levels in the vertical direction Z, and the rear-surface via 182 may be connected between rear-surface wiring layers 184 that are arranged at different vertical levels. The rear-surface via 182 may be disposed on the second contact 170, and the second contact 170 may be connected to the rear-surface wiring layer 184 via the rear-surface via 182. A portion of the rear-surface wiring layer 184 may have a pad shape to apply a power voltage or a ground voltage to the diode structure DS. Accordingly, the power voltage or the ground voltage may be applied to the diode structure DS via the portion of the rear-surface wiring layer 184, and a current path may be formed in the diode structure DS in the vertical direction Z.

ESD protection elements generally included in integrated circuit devices include diodes connected between a power/ground connection unit and an integrated circuit pin connection unit. Diodes are designed to turn on when static electricity is generated and to rapidly discharge static electricity to protect integrated circuit devices. However, as the thickness and/or volume of a silicon substrate decreases, the resistance of a diode increases when the diode is turned on, making efficient ESD protection difficult. To solve this problem, a "gate-bounded diode" has been proposed, which forms a diode within a silicon region (for example, within a semiconductor layer used as source/drain regions) of an integrated circuit device. However, in the gate-bounded diode, an N+ region and a P+ region which are arranged laterally and a substrate disposed below the N+ region and the P+ region form a current path of a diode, and thus, a substrate with a relatively large thickness is desirable for efficient ESD protection.

According to the above embodiments of the present inventive concept, the upper semiconductor layer 122 that is disposed on the first surface 110F1 of the substrate 110 and the lower semiconductor layer 124 that is disposed on the second surface 110F2 of the substrate 110 may respectively function as an N+ region and a P+ region, and the first well region WE1 and the second well region WE2 may be formed within the substrate 110, thereby forming a vertical diode. Therefore, even when the substrate 110 is thin (or regardless of the thickness of the substrate 110), a p-n junction having a relatively large area may be secured, and efficient ESD protection may be implemented.

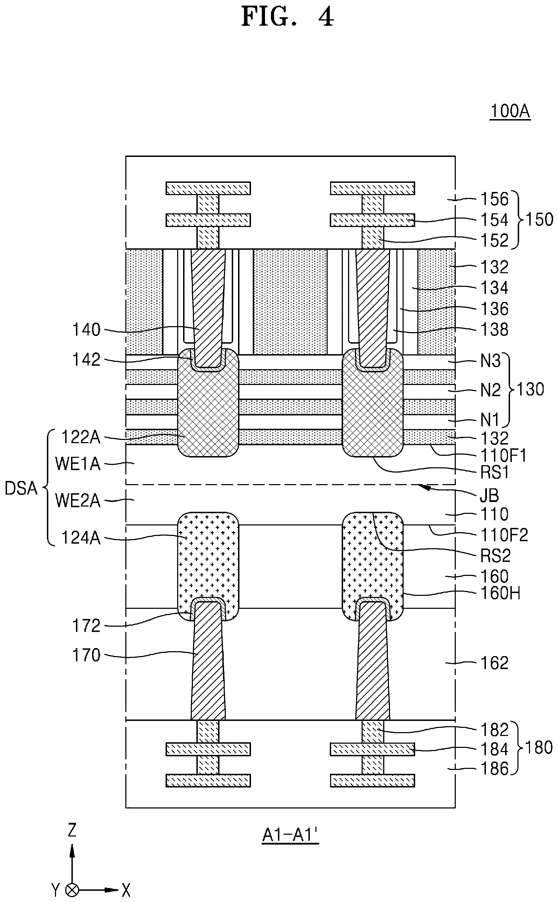

FIG. 4 is a cross-sectional view of an integrated circuit device 100A according to embodiments of the present inventive concept. In FIG. 4, the same reference symbols as those in FIGS. 1 to 3 may denote like elements, and thus, redundant descriptions may be omitted.

Referring to FIG. 4, a diode structure DSA may include an upper semiconductor layer 122A, a lower semiconductor layer 124A, a first well region WE1A, and a second well region WE2A.

The upper semiconductor layer 122A may include a first dopant of a first conductivity type, and for example, the first conductivity type may be p type. The upper semiconductor layer 122A may be a region including a relatively high concentration of the first dopant, and for example, may be referred to as a P+ region. The lower semiconductor layer 124A may include a second dopant of a second conductivity type, and the second conductivity type may be different from the first conductivity type. For example, the second conductivity type may be n type. The lower semiconductor layer 124A may be a region including a relatively high concentration of the second dopant, and for example, may be referred to as an N+ region.

The first well region WE1A may be in contact with the upper semiconductor layer 122A, and may include a third dopant of the first conductivity type. For example, the first well region WE1A may be an impurity region formed by ion planting the third dopant into a first portion of the substrate 110, the first portion being adjacent to the first surface 1 10F1 of the substrate 110. The second well region WE2A may be in contact with the lower semiconductor layer 124, and may include a fourth dopant of the second conductivity type. For example, the second well region WE2A may be an impurity region formed by ion planting the fourth dopant into a second portion of the substrate 110, the second portion being adjacent to the second surface 110F2 of the substrate 110.

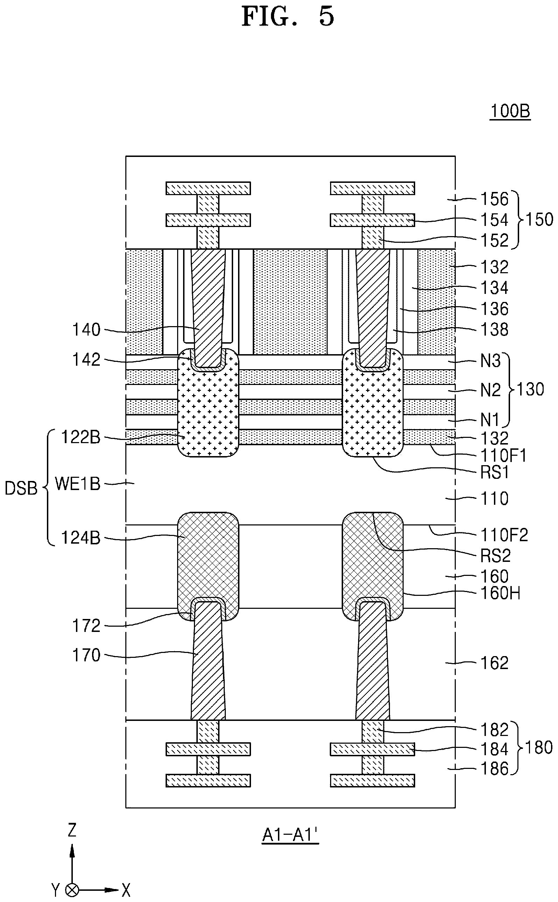

FIG. 5 is a cross-sectional view of an integrated circuit device 100B according to embodiments of the present inventive concept.

Referring to FIG. 5, a diode structure DSB may include an upper semiconductor layer 122B, a lower semiconductor layer 124B, and the first well region WE1A.

The upper semiconductor layer 122B may be disposed on the first surface 110F1 of the substrate 110. The upper semiconductor layer 122B may include a first dopant of a first conductivity type, and for example, the first conductivity type may be n type. The upper semiconductor layer 122B may be a region including a relatively high concentration of the first dopant, and for example, may be referred to as an N+ region.

The lower semiconductor layer 124B may be disposed on the second surface 110F2 of the substrate 110. The lower semiconductor layer 124B may include a second dopant of a second conductivity type, and the second conductivity type may be different from the first conductivity type. For example, the second conductivity type may be p type. The lower semiconductor layer 124B may be a region including a relatively high concentration of the second dopant, and for example, may be referred to as a P+ region.

A first well region WE1B may be arranged in the substrate 110 between the upper semiconductor layer 122B and the lower semiconductor layer 124B, and may be in contact with both the upper semiconductor layer 122B and the lower semiconductor layer 124B. For example, as shown in FIG. 5, the first well region WE1B may be arranged over the entire thickness of the substrate 110.

In embodiments of the present inventive concept, the first well region WE1B may include a third dopant of the first conductivity type. For example, the first well region WE1B may be an impurity region formed by ion planting the third dopant into a first portion of the substrate 110, the first portion being adjacent to the first surface 110F1 of the substrate 110.

In embodiments of the present inventive concept, the substrate 110 may be formed to be relatively thin, and for example, a bulkless transistor element may be disposed on another portion of the substrate 110. In embodiments of the present inventive concept, the substrate 110 may have a thickness of about 30 nm to about 300 nm, but the thickness of the substrate 110 is not limited thereto.

In embodiments of the present inventive concept, with reference to FIG. 5, because the first well region WE1B is of the first conductivity type, for example, n type, a p-n junction may be formed at a boundary between the first well region WE1B and the lower semiconductor layer 124B.

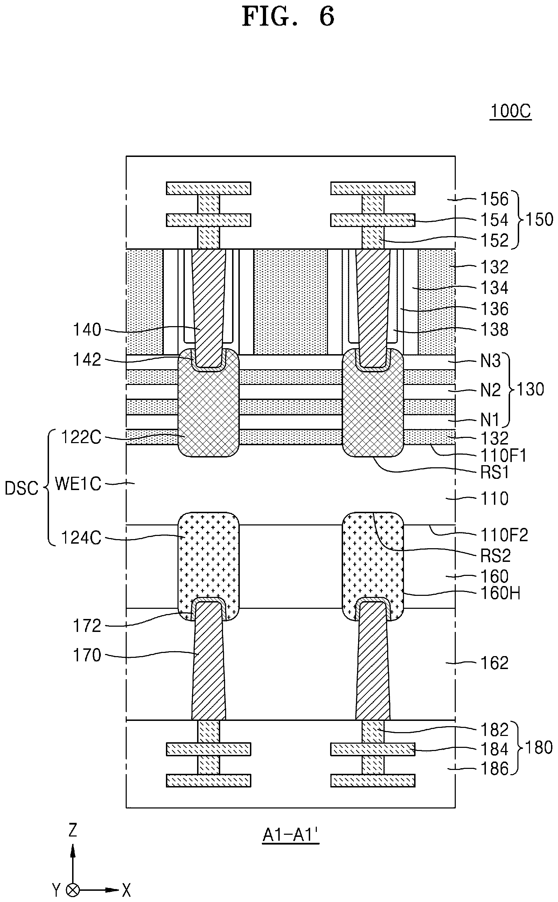

FIG. 6 is a cross-sectional view of an integrated circuit device 100C according to embodiments of the present inventive concept.

Referring to FIG. 6, a diode structure DSC may include an upper semiconductor layer 122C, a lower semiconductor layer 124C, and a first well region WE1C.

The upper semiconductor layer 122C may be disposed on the first surface 110F1 of the substrate 110. The upper semiconductor layer 122C may include a first dopant of a first conductivity type, and for example, the first conductivity type may be p type. The upper semiconductor layer 122C may be a region including a relatively high concentration of the first dopant, and for example, may be referred to as a P+ region.

The lower semiconductor layer 124C may be disposed on the second surface 110F2 of the substrate 110. The lower semiconductor layer 124C may include a second dopant of a second conductivity type, and the second conductivity type may be different from the first conductivity type. For example, the second conductivity type may be n type. The lower semiconductor layer 124C may be a region including a relatively high concentration of the second dopant, and for example, may be referred to as an N+ region.

The first well region WE1C may be arranged in the substrate 110 between the upper semiconductor layer 122C and the lower semiconductor layer 124C, and may be in contact with both the upper semiconductor layer 122C and the lower semiconductor layer 124C. For example, as shown in FIG. 6, the first well region WE1C may be arranged over the entire thickness of the substrate 110.

In embodiments of the present inventive concept, the first well region WE1C may include a third dopant of the first conductivity type (for example, p type). For example, the first well region WE1C may be an impurity region formed by ion planting the third dopant into a first portion of the substrate 110, and the first portion may be adjacent to the first surface 110F1 of the substrate 110.

In embodiments of the present inventive concept, the substrate 110 may be formed to be relatively thin, and for example, a bulkless transistor element may be disposed on another portion of the substrate 110. In embodiments of the present inventive concept, the substrate 110 may have a thickness of about 30 nm to about 300 nm, but the thickness of the substrate 110 is not limited thereto.

In embodiments of the present inventive concept, with reference to FIG. 6, because the first well region WE1C is of the first conductivity type, for example, p type, a p-n junction may be formed at a boundary between the first well region WE1C and the lower semiconductor layer 124C.

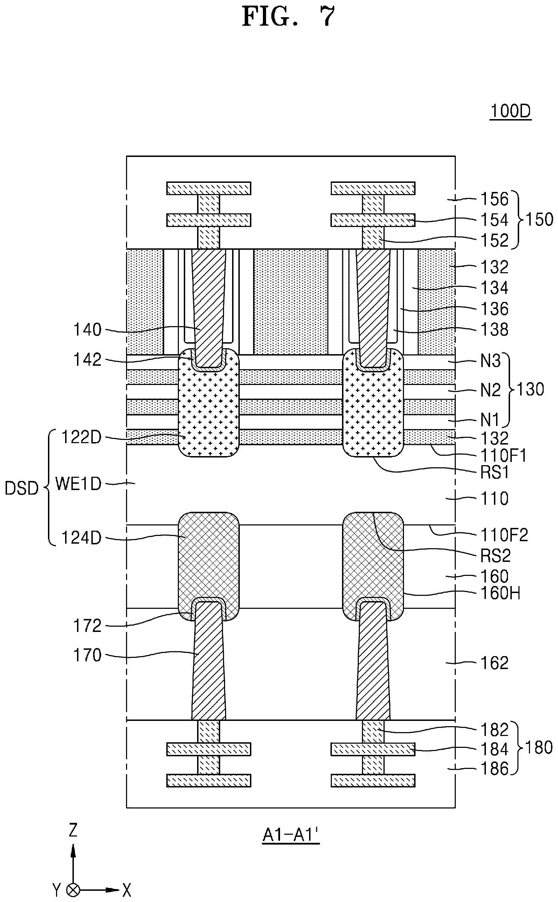

FIG. 7 is a cross-sectional view of an integrated circuit device 100D according to embodiments of the present inventive concept.

Referring to FIG. 7, a diode structure DSD may include an upper semiconductor layer 122D, a lower semiconductor layer 124D, and a first well region WE1D.

The upper semiconductor layer 122D may include a first dopant of a first conductivity type, and for example, the first conductivity type may be n type, and for example, may be referred to as an N+ region. The lower semiconductor layer 124D may include a second dopant of a second conductivity type, and the second conductivity type may be different from the first conductivity type. For example, the second conductivity type may be p type, and for example, may be referred to as a P+ region.

The first well region WE1D may be arranged in the substrate 110 between the upper semiconductor layer 122D and the lower semiconductor layer 124D, and may be in contact with both the upper semiconductor layer 122D and the lower semiconductor layer 124D. The first well region WE1D may include a fourth dopant of the second conductivity type.

In embodiments of the present inventive concept, with reference to FIG. 7, because the first well region WE1D is of the second conductivity type, for example, p type, a p-n junction may be formed at a boundary between the first well region WE1D and the upper semiconductor layer 122D.

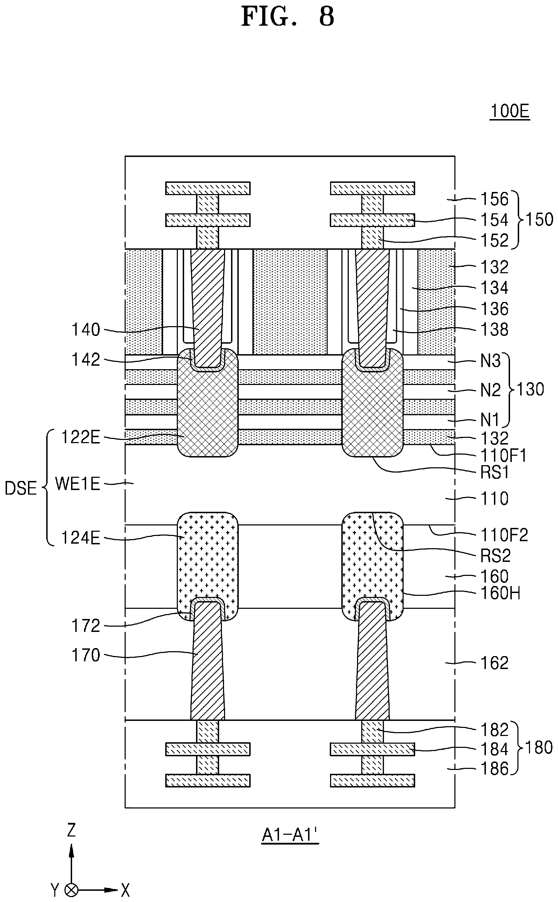

FIG. 8 is a cross-sectional view of an integrated circuit device 100E according to embodiments of the present inventive concept.

Referring to FIG. 8, a diode structure DSE may include an upper semiconductor layer 122E, a lower semiconductor layer 124E, and a first well region WE1E.

The upper semiconductor layer 122E may include a first dopant of a first conductivity type, and for example, the first conductivity type may be p type, and for example, may be referred to as a P+ region. The lower semiconductor layer 124E may include a second dopant of a second conductivity type, and the second conductivity type may be different from the first conductivity type. For example, the second conductivity type may be n type, and for example, may be referred to as an N+ region.

The first well region WE1E may be arranged in the substrate 110 between the upper semiconductor layer 122E and the lower semiconductor layer 124E, and may be in contact with both the upper semiconductor layer 122E and the lower semiconductor layer 124E. The first well region WE1E may include a fourth dopant of the second conductivity type (for example, n type).

In embodiments of the present inventive concept, with reference to FIG. 8, because the first well region WE1E is of the second conductivity type, for example, n type, a p-n junction may be formed at a boundary between the first well region WE1E and the upper semiconductor layer 122E.

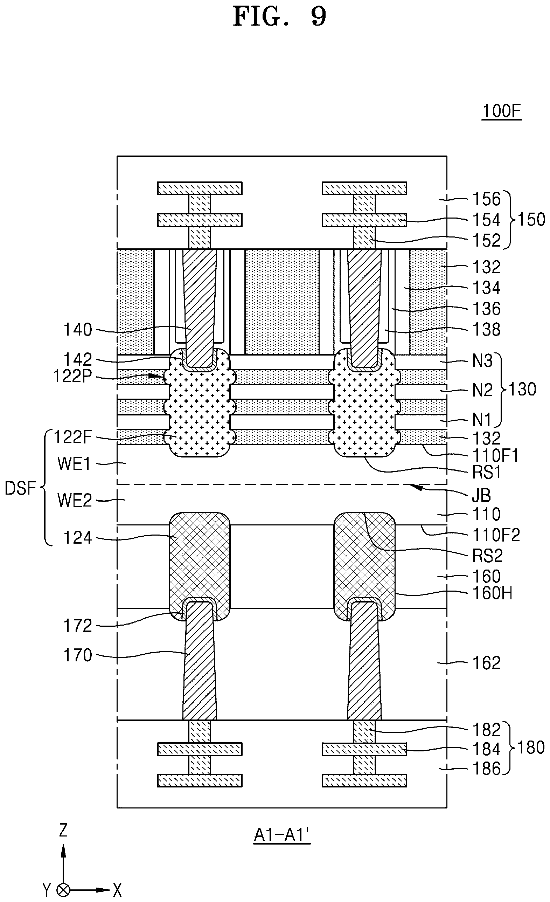

FIG. 9 is a cross-sectional view of an integrated circuit device 100F according to embodiments of the present inventive concept.

Referring to FIG. 9, a diode structure DSF may include an upper semiconductor layer 122F, the lower semiconductor layer 124, the first well region WE1, and the second well region WE2.

The upper semiconductor layer 122F may have a sidewall profile that is different from a sidewall profile of the lower semiconductor layer 124. For example, a first portion of a sidewall of the upper semiconductor layer 122F may be in contact with the nanosheet structure 130, and a second portion of the sidewall of the upper semiconductor layer 122F may be in contact with the cover insulating line 132. The second portion of the sidewall of the upper semiconductor layer 122F may protrude outward with respect to the first portion of the sidewall of the upper semiconductor layer 122F. Outward may be refer to outward in the first horizontal direction X. The second portion of the sidewall of the upper semiconductor layer 122F may be referred to as a protrusion 122P.

For example, a portion of the cover insulating line 132, which is in contact with the protrusion 122P of the upper semiconductor layer 122F, may be recessed inward along the shape of the protrusion 122P of the upper semiconductor layer 122F. For example, the protrusion 122P may be formed in the recesses of the cover insulating line 132.

Unlike the protrusion 122P formed on the sidewall of the upper semiconductor layer 122F, the lower semiconductor layer 124 may have a sidewall profile surrounded by the mold insulating layer 160 and extending substantially vertically.

In embodiments of the present inventive concept, the upper semiconductor layer 122F may be formed simultaneously in a manufacturing process for forming source/drain regions included in an MBCFET element that may be formed on another portion of the substrate 110. In the manufacturing process for forming source/drain regions, a lateral etching process may be additionally performed before the upper semiconductor layer 122F is formed in the first recess region RS1, and in this case, the upper semiconductor layer 122F may be formed to include the protrusion 122P protruding toward the cover insulating line 132.

In embodiments of the present inventive concept, in the diode structures DSA, DSB, DSC, DSD, and DSE described with reference to FIGS. 3 to 8, the upper semiconductor layers 122A to 122E may be modified to include the protrusion 122P.

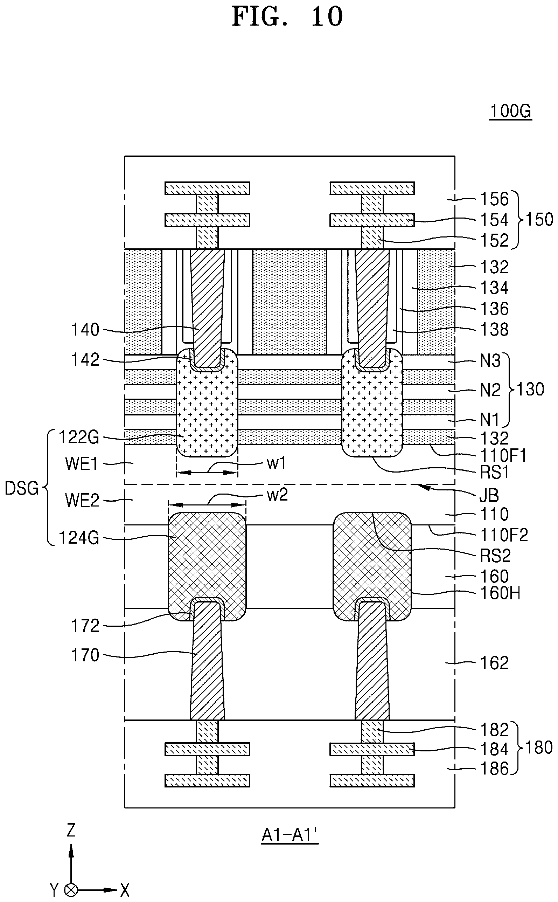

FIG. 10 is a cross-sectional view of an integrated circuit device 100G according to embodiments of the present inventive concept.

Referring to FIG. 10, the diode structure DSG may include an upper semiconductor layer 122G, a lower semiconductor layer 124G, the first well region WE1, and the second well region WE2.

The upper semiconductor layer 122G may have a first width w1 in the first horizontal direction X, and the lower semiconductor layer 124G may have a second width w2 in the first horizontal direction X. The second width w2 may be different from the first width w1. For example, as shown in FIG. 10, the second width w2 of the lower semiconductor layer 124G may be greater than the first width w1 of the upper semiconductor layer 122G. However, in embodiments of the present inventive concept, the second width w2 of the lower semiconductor layer 124G may be less than the first width w1 of the upper semiconductor layer 122G.

For example, the first width w1 of the upper semiconductor layer 122G may be formed to be the same as the width of source/drain regions included in an MBCFET element that may be formed on another portion of the substrate 110. The second width w2 of the lower semiconductor layer 124G may be selected independently of the first width w1 of the upper semiconductor layer 122G.

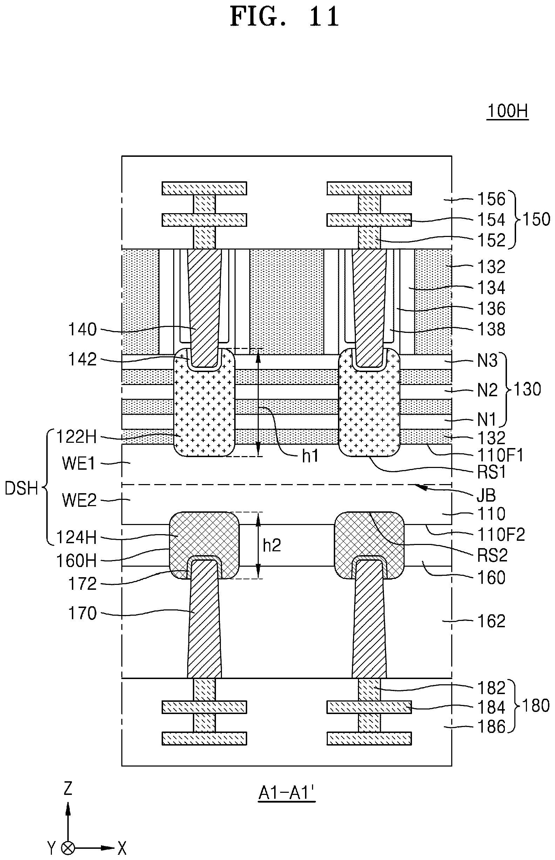

FIG. 11 is a cross-sectional view of an integrated circuit device 100H according to embodiments of the present inventive concept.

Referring to FIG. 11, a diode structure DSH may include an upper semiconductor layer 122H, a lower semiconductor layer 124H, the first well region WE1, and the second well region WE2.

The upper semiconductor layer 122H may have a first height h1 in the vertical direction Z, and the lower semiconductor layer 124H may have a second height h2 in the vertical direction Z. The second height h2 may be different from the first height h1. For example, as shown in FIG. 11, the second height h2 of the lower semiconductor layer 124H may be less than the first height h1 of the upper semiconductor layer 122H. However, in embodiments of the present inventive concept, the second height h2 of the lower semiconductor layer 124H may be greater than the first height h1 of the upper semiconductor layer 122H.

For example, the first height h1 of the upper semiconductor layer 122H may be formed to be substantially the same as the height of source/drain regions that are included in an MBCFET element that may be formed on another portion of the substrate 110. The second height h2 of the lower semiconductor layer 124H may be selected independently of the first height h1 of the upper semiconductor layer 122H.

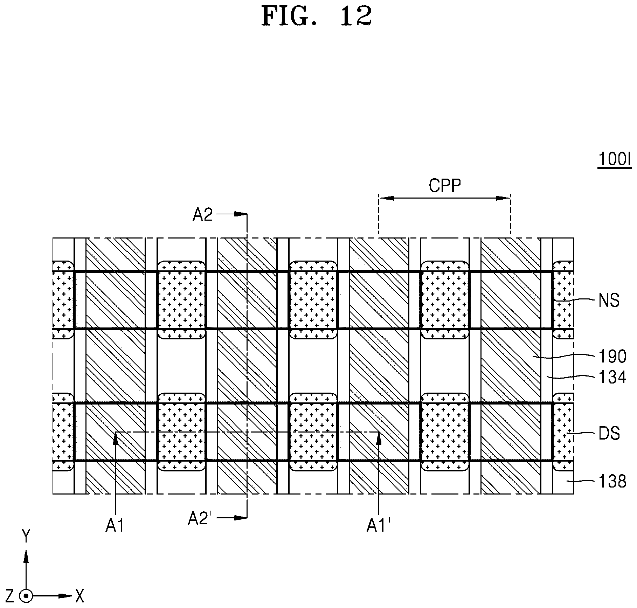

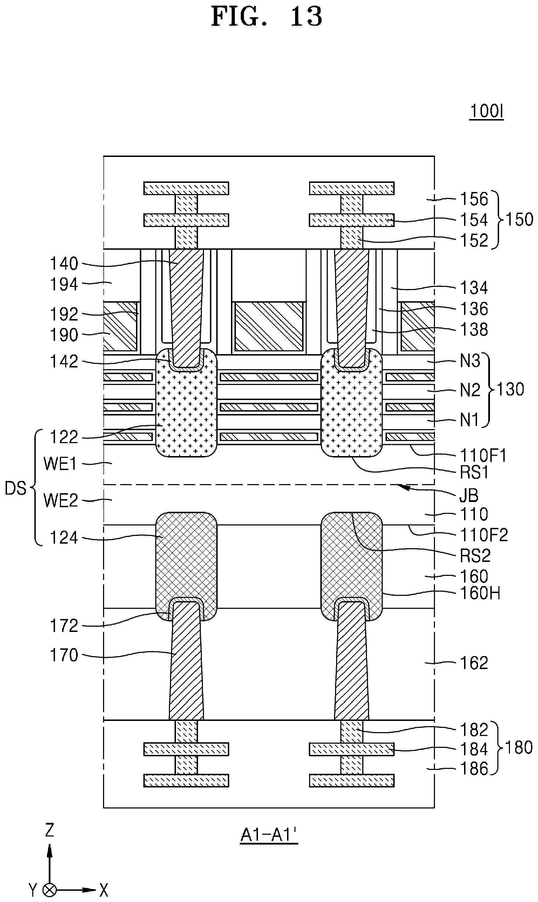

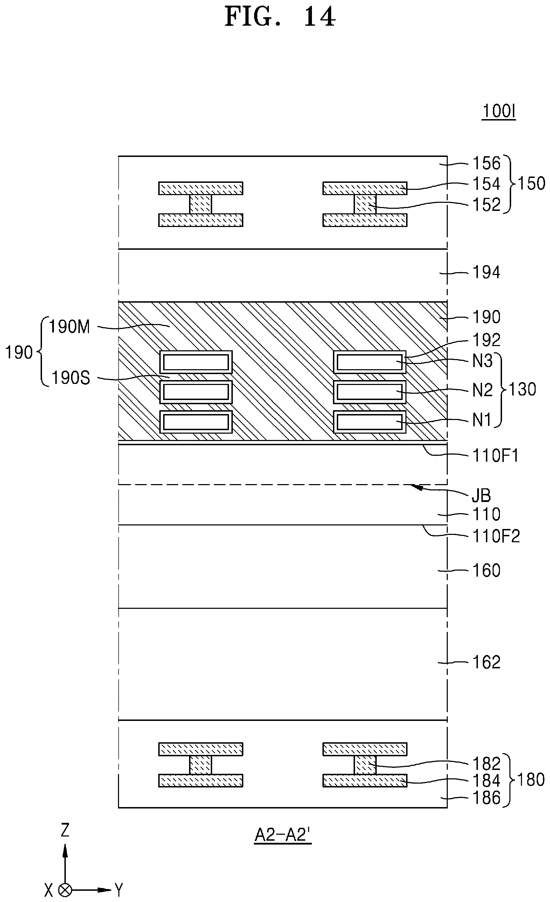

FIG. 12 is a layout of an integrated circuit device 100I according to embodiments of the present inventive concept, and FIG. 13 is a cross-sectional view of the integrated circuit device 100I taken along line A1-A1' of FIG. 12. FIG. 14 is a cross-sectional view of the integrated circuit device 100I of FIG. 12 taken along line A2-A2' of FIG. 12.

Referring to FIGS. 12 to 14, the nanosheet structure 130 may be at least partially surrounded by a dummy gate line 190 instead of the cover insulating line 132. The dummy gate line 190 may extend in the second horizontal direction Y to at least partially surround the nanosheet structure 130, for example, the first nanosheet N1, the second nanosheet N2, and the third nanosheet N3, and a plurality of dummy gate lines 190 may be arranged spaced apart from each other in the first horizontal direction X at the reference interval CPP.

In embodiments of the present inventive concept, the dummy gate line 190 may include a main gate portion 190M and a sub-gate portion 190S. The main gate portion 190M may cover an upper surface of the third nanosheet N3 and extend in the second horizontal direction Y, and the pair of spacers 134 may be arranged on both sides of the main gate portion 190M. The sub-gate portion 190S may be arranged between the first surface 110F1 of the substrate 110 and the first nanosheet N1, between the first nanosheet N1 and the second nanosheet N2, and between the second nanosheet N2 and the third nanosheet N3.

In embodiments of the present inventive concept, a fin-shaped active region extending in the first horizontal direction X and protruding in the vertical direction Z may be defined in the first surface 110F1 of the substrate 110, and an element isolation film may be disposed on both sides of the fin-shaped active region. In this case, the nanosheet structure 130 is disposed on the fin-shaped active region, and the dummy gate line 190 may at least partially surround the nanosheet structure 130 and extend on an upper surface of the element isolation film and an upper surface of the fin-shaped active region in the second horizontal direction Y.

In embodiments of the present inventive concept, the dummy gate line 190 may include doped polysilicon, metal, conductive metal nitride, conductive metal carbide, conductive metal silicide, or a combination thereof. For example, the dummy gate line 190 may include Al, Cu, Ti, Ta, W, Mo, TaN, NiSi, CoSi, TiN, WN, TiAl, TiAlN, TaCN, TaC, TaSiN, or a combination thereof, but the present inventive concept is not limited thereto. In embodiments of the present inventive concept, the dummy gate line 190 may include a work function metal-containing layer and a gap-fill metal film. The work function metal-containing layer may include at least one of, for example, Ti, W, Ru, Nb, Mo, Hf, Ni, Co, Pt, Yb, Tb, Dy, Er, and/or Pd. The gap-fill metal film may include a W film or an Al film. In embodiments of the present inventive concept, the dummy gate line 190 may include a stacked structure of TiAlC/TiN/W, a stacked structure of TiN/TaN/TiAlC/TiN/W, or a stacked structure of TiN/TaN/TiN/TiAlC/TiN/W, but the present inventive concept is not limited thereto.

A gate insulating layer 192 may be arranged between the dummy gate line 190 and the nanosheet structure 130. For example, the gate insulating layer 192 may be arranged between the main gate portion 190M of the dummy gate line 190 and the third nanosheet N3, between the sub-gate portion 190S and the nanosheet structure 130, and between the sub-gate portion 190S and an upper surface of the first surface 110F1 of the substrate 110.

In embodiments of the present inventive concept, the gate insulating layer 192 may include a silicon oxide film, a silicon oxynitride film, a high-k dielectric film having a higher dielectric constant than a silicon oxynitride film, or a combination thereof. The high-k dielectric film may include a metal oxide or a metal oxynitride. For example, a high-k dielectric film that may be used as the gate insulating layer 192 may include HfO₂, HfSiO, HfSiON, HfTaO, HfTiO, HfZrO, ZrO₂, Al₂O₃, or a combination thereof, but the present inventive concept is not limited thereto.

A gate capping layer 194 may be disposed on the dummy gate line 190. In embodiments of the present inventive concept, the gate capping layer 194 may include silicon oxide (SiOₓ), silicon nitride (SiNₓ), silicon oxynitride (SiOₓN_{y}), silicon carbonitride (SiCₓN_{y}), silicon oxycarbonitride (SiOₓC_{y}N_{z}), or a combination thereof.

In embodiments of the present inventive concept, the dummy gate line 190 may be formed simultaneously in a manufacturing process for forming a gate line included in an MBCFET element that may be formed on another portion of the substrate 110. In addition, a separate contact might not be connected to the dummy gate line 190, and the dummy gate line 190 may be configured to float because no signal or voltage is applied to the dummy gate line 190.

In embodiments of the present inventive concept, the integrated circuit devices 100A, 100B, 100C, 100D, 100E, 100F, 100G, and 100H described with reference to FIGS. 3 to 11 may be modified to include the dummy gate line 190 instead of the cover insulating line 132.

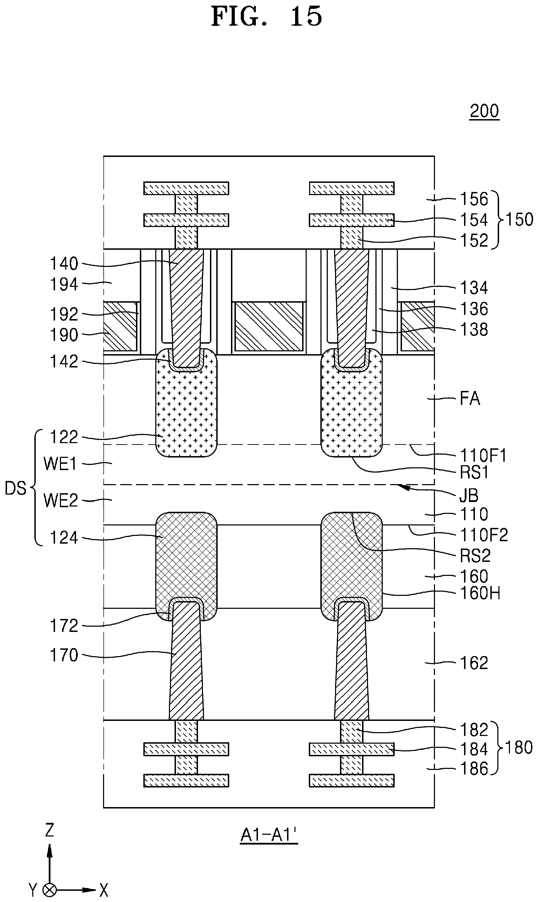

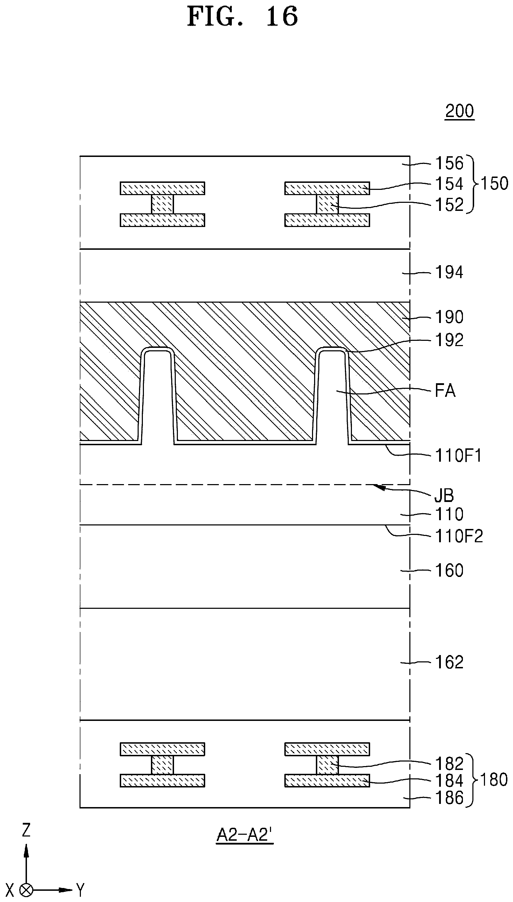

FIGS. 15 and 16 are cross-sectional views of an integrated circuit device 200 according to embodiments of the present inventive concept.

Referring to FIGS. 15 and 16, a fin-shaped active region FA may be arranged in the first surface 110F1 of the substrate 110. The fin-shaped active region FA may be arranged to protrude from the first surface 110F1 of the substrate 110 in the vertical direction Z and may extend in the first horizontal direction X.

The dummy gate line 190 extending in the second horizontal direction Y may be disposed on the fin-shaped active region FA. The gate insulating layer 192 may be arranged between the fin-shaped active region FA and the dummy gate line 190 and may extend in the second horizontal direction Y. The gate insulating layer 192 may be arranged between sidewalls of the fin-shaped active region FA and the dummy gate line and between the upper surface of the fin-shaped active region FA and the dummy gate line 190. The gate insulating layer 192 may extend on sidewalls and a lower surface of the dummy gate line 190. A portion of the gate insulating layer 192 may be arranged between the dummy gate line 190 and the pair of spacers 134.

In embodiments of the present inventive concept, the fin-shaped active region FA may be formed simultaneously in a manufacturing process for forming a fin-shaped active region included in a fin-shaped FET element that may be formed on another portion of the substrate 110. In addition, a separate contact might not be connected to the dummy gate line 190, and the dummy gate line 190 may be configured to float because no signal or voltage is applied.

In embodiments of the present inventive concept, the integrated circuit devices 100A, 100B, 100C, 100D, 100E, 100F, 100G, 100H, and 100I described with reference to FIGS. 3 to 14 may be modified to include the fin-shaped active region FA instead of the nanosheet structure 130.

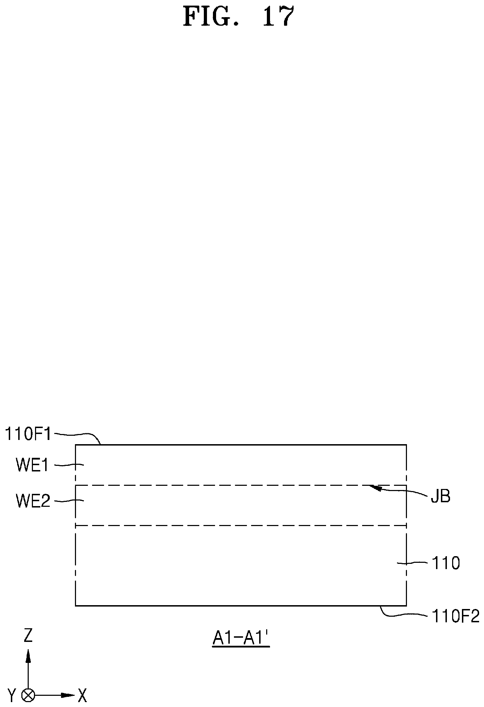

FIGS. 17 to 32 are cross-sectional views of a method of manufacturing the integrated circuit device 100, according to embodiments of the present inventive concept. FIGS. 17 to 32 are cross-sectional views corresponding to a cross-section taken along line A1-A1' of FIG. 1.

Referring to FIG. 17, the first well region WE1 may be formed in the substrate 110 that is adjacent to the first surface 110F1 by ion planting a third dopant of a first conductivity type via the first surface 110F1 of the substrate 110. Afterwards, the second well region WE2 may be formed below the first well region WE1 and in the substrate 110 by ion planting a fourth dopant of a second conductivity type via the first surface 110F1 of the substrate 110.

In embodiments of the present inventive concept, the first conductivity type may be n type and the second conductivity type may be p type. For example, the third dopant may include phosphorus or arsenic and the fourth dopant may include boron. The first well region WE1 and the second well region WE2 may be arranged to vertically overlap (or overlay) each other in the substrate 110, and the junction boundary JB may be formed between the first well region WE1 and the second well region WE2.

In embodiments of the present inventive concept, an ion plantation process for forming the second well region WE2 may be performed before an ion plantation process for forming the first well region WE1.

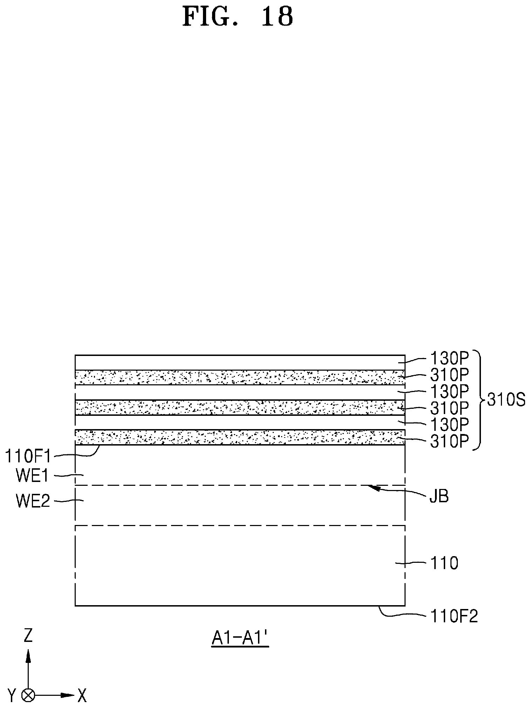

Referring to FIG. 18, a sacrificial layer 310P and a channel semiconductor layer 130P may be alternately formed with each other on the first surface 110F1 of the substrate 110 to form a channel stack 310S.

In embodiments of the present inventive concept, the sacrificial layer 310P and the channel semiconductor layer 130P may be formed by an epitaxy process. In embodiments of the present inventive concept, the sacrificial layer 310P and the channel semiconductor layer 130P may include a material having an etch selectivity relative to each other. For example, each of the sacrificial layer 310P and the channel semiconductor layer 130P may include a single crystal layer of a Group IV semiconductor, a Group IV-IV compound semiconductor, or a Group III-V compound semiconductor, and the sacrificial layer 310P and the channel semiconductor layer 130P may include different materials from each other. In embodiments of the present inventive concept, the sacrificial layer 310P may include SiGe and the nanosheet structure 130 may include single crystal silicon.

In embodiments of the present inventive concept, the epitaxy process may be a vapor-phase epitaxy (VPE), or a chemical vapor deposition (CVD) process such as ultra-high vacuum CVD, molecular beam epitaxy, or a combination thereof. In the epitaxy process, a liquid or gaseous precursor may be used as a precursor to form the sacrificial layer 310P and the channel semiconductor layer 130P.

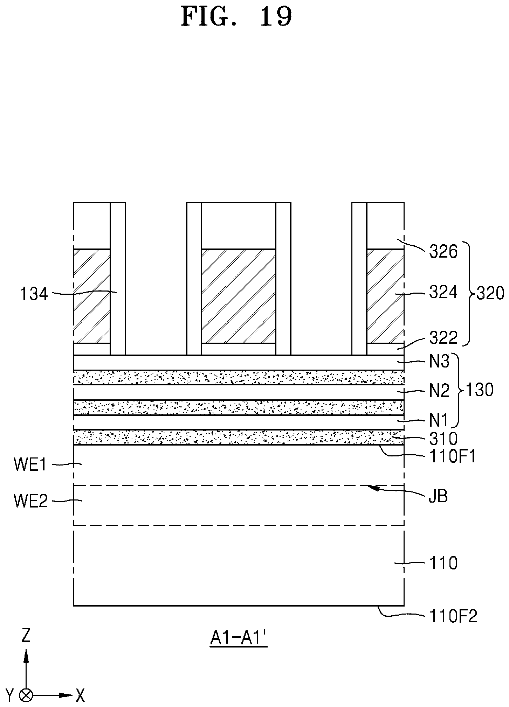

Referring to FIG. 19, after a hard mask pattern extending to have a predetermined length in a first direction (X direction) is formed on the uppermost channel semiconductor layer 130P, the sacrificial layer 310P and the channel semiconductor layer 130P are patterned by using the hard mask pattern as an etch mask to form a sacrificial layer pattern 310 and the nanosheet structure 130.

For example, the nanosheet structure 130 may include the first nanosheet N1, the second nanosheet N2, and the third nanosheet N3, which are spaced apart from each other on the first surface 110F1 of the substrate 110 in the vertical direction Z. The sacrificial layer pattern 310 may be arranged between the first surface 110F1 of the substrate 110 and the first nanosheet N1, between the first nanosheet N1 and the second nanosheet N2, and between the second nanosheet N2 and the third nanosheet N3.

Afterwards, a sacrificial gate structure 320 may be formed on the sacrificial layer pattern 310 and the nanosheet structure 130. The sacrificial gate structure 320 may include a sacrificial insulating layer pattern 322, a sacrificial gate line 324, and a sacrificial gate capping layer 326.

The sacrificial insulating layer pattern 322 may extend in the second horizontal direction Y and may be conformally formed on upper surfaces and sidewalls of the sacrificial layer pattern 310 and the nanosheet structure 130, and the first surface 110F1 of the substrate 110. In embodiments of the present inventive concept, the sacrificial insulating layer pattern 322 may include a material having an etch selectivity with respect to the sacrificial gate line 324, and for example, may include at least one film such as thermal oxide, silicon oxide, and silicon nitride.

The sacrificial gate line 324 may be formed to have a relatively large height to cover the sacrificial layer pattern 310 and the nanosheet structure 130 on the sacrificial insulating layer pattern 322. An upper surface of the sacrificial gate line 324 may have a flat level. In embodiments of the present inventive concept, the sacrificial gate line 324 may include polysilicon, but the present inventive concept is not limited thereto.

The sacrificial gate capping layer 326 may be disposed on the upper surface of the sacrificial gate line 324. In embodiments of the present inventive concept, the sacrificial gate capping layer 326 may include a silicon nitride film.

The pair of spacers 134 may be disposed on sidewalls of the sacrificial insulating layer pattern 322, the sacrificial gate line 324, and the sacrificial gate capping layer 326. In embodiments of the present inventive concept, the pair of spacers 134 may include silicon oxide (SiOₓ), silicon nitride (SiNₓ), silicon oxynitride (SiOₓN_{y}), silicon carbonitride (SiCₓN_{y}), silicon oxycarbonitride (SiOₓC_{y}N_{z}), or a combination thereof.

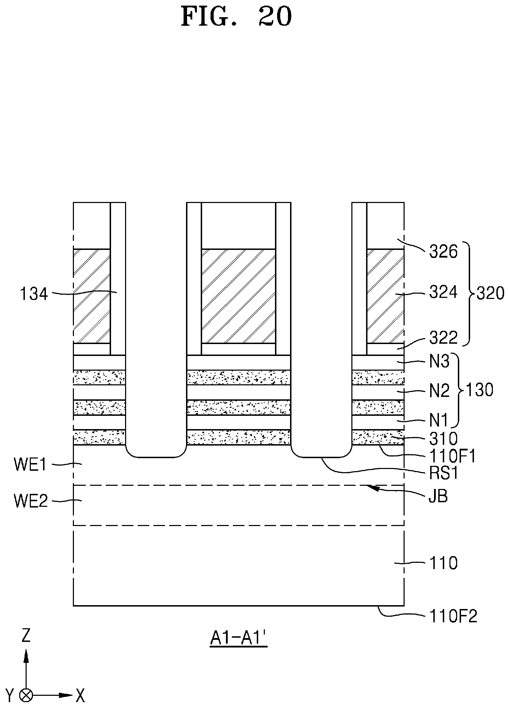

Referring to FIG. 20, portions of the sacrificial layer pattern 310, portions of the nanosheet structure 130, and a portion of the substrate 110, which are arranged on both sides of the sacrificial gate structure 320, may be etched to form the first recess region RS1 on both sides of the sacrificial gate structure 320. As the first recess region RS1 is formed, the nanosheet structure 130 may be separated into a plurality of nanosheet structures 130 in the first horizontal direction X.

In embodiments of the present inventive concept, as shown in FIG. 20, the first recess region RS1 includes a sidewall that is aligned with a sidewall of the sacrificial gate structure 320, for example, a sidewall of a spacer of the pair of spacers 134, and that extends continuously.

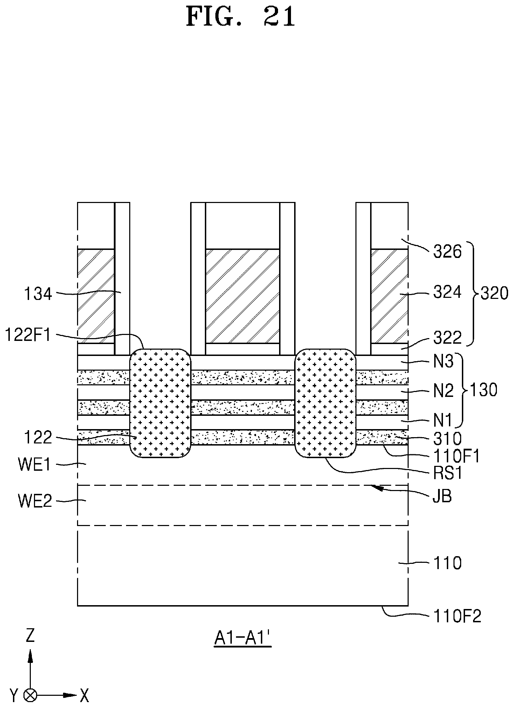

Referring to FIG. 21, the upper semiconductor layer 122 may be formed in the first recess region RS1. For example, the upper semiconductor layer 122 may be formed by epitaxially growing a semiconductor material from surfaces of the nanosheet structure 130, the sacrificial layer pattern 310, and the substrate 110, the surfaces being exposed to an inner wall of the first recess region RS1.

In embodiments of the present inventive concept, the upper semiconductor layer 122 may be formed by using at least one semiconductor material such as Si, SiGe, SiP, SiGeB, and/or SiGeC. In embodiments of the present inventive concept, during an epitaxy process for forming the upper semiconductor layer 122, a first dopant of a first conductivity type may be doped together. In addition, after the epitaxy process for forming the upper semiconductor layer 122, the first dopant may be ion planted. The upper semiconductor layer 122 may be a region including a relatively high concentration of the first dopant, and for example, may be referred to as an N+ region.

A first surface 122F1 of the upper semiconductor layer 122 may be arranged at a level higher than that of an upper surface of the nanosheet structure 130 and may protrude above the upper surface of the nanosheet structure 130.

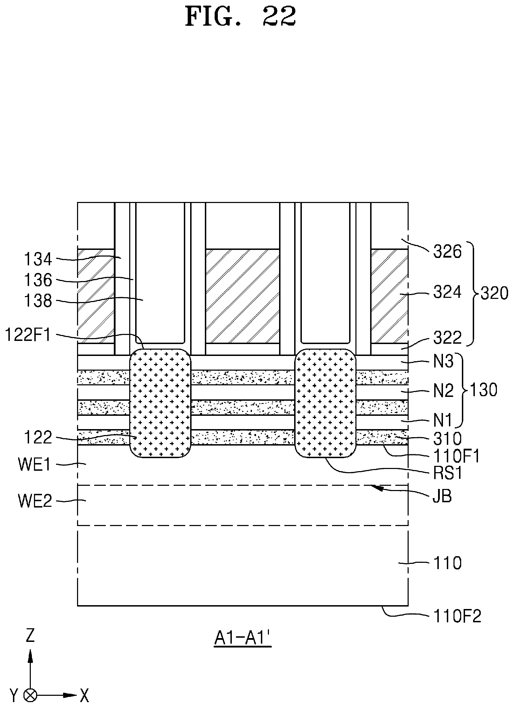

Referring to FIG. 22, the etch stop film 136 is formed to cover the first surface 122F1 of the upper semiconductor layer 122, and the first buried insulating layer 138 may be formed on the etch stop film 136 to fill a space between sacrificial gate structures 320.

In embodiments of the present inventive concept, a planarization process is performed on an upper side of the first buried insulating layer 138 such that an upper surface of the sacrificial gate structure 320 is not covered by the first buried insulating layer 138 and may be arranged at substantially the same vertical level as an upper surface of the first buried insulating layer 138.

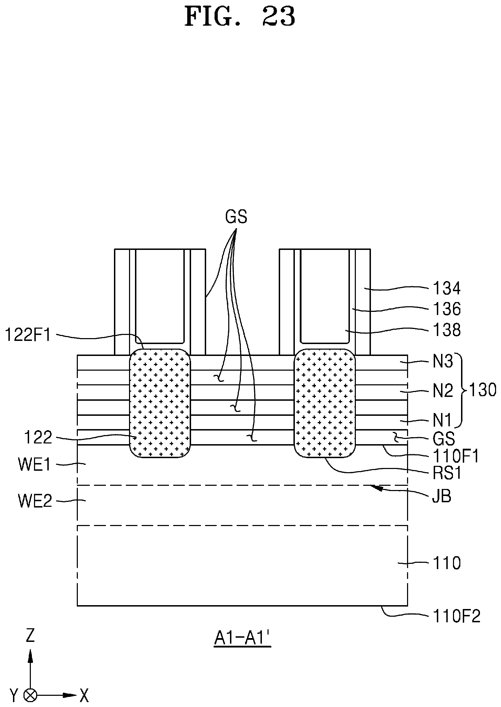

Referring to FIG. 23, the sacrificial gate structure 320 may be removed.

In embodiments of the present inventive concept, the sacrificial gate capping layer 326, the sacrificial gate line 324, and the sacrificial insulating layer pattern 322 may be sequentially removed. A space from which the sacrificial gate structure 320 is removed may be referred to as a gate space GS. In embodiments of the present inventive concept, the gate space GS may be disposed between the pair of spacers 134, and a sidewall of the sacrificial layer pattern 310 and an upper surface and sidewall of the nanosheet structure 130 may be exposed in the gate space GS.

Afterwards, the sacrificial layer pattern 310 remaining in the gate space GS may be removed. A process of removing the sacrificial layer pattern 310 may be a wet etching process by using an etch selectivity between the sacrificial layer pattern 310 and the nanosheet structure 130.

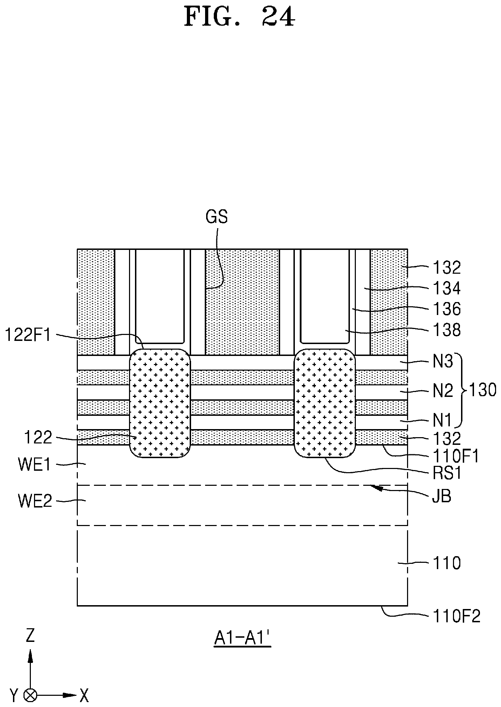

Referring to FIG. 24, the cover insulating line 132 may be formed in the gate space GS. The cover insulating line 132 may include, for example, silicon oxide (SiOₓ), silicon nitride (SiNₓ), silicon oxynitride (SiOₓN_{y}), silicon carbonitride (SiCₓN_{y}), and/or silicon oxycarbonitride (SiOₓC_{y}N_{z}).

The cover insulating line 132 may fill the inside of the gate space GS that is disposed between the pair of spacers 134 and may fill spaces between the first to third nanosheets N1, N2, and N3 of the nanosheet structure 130.

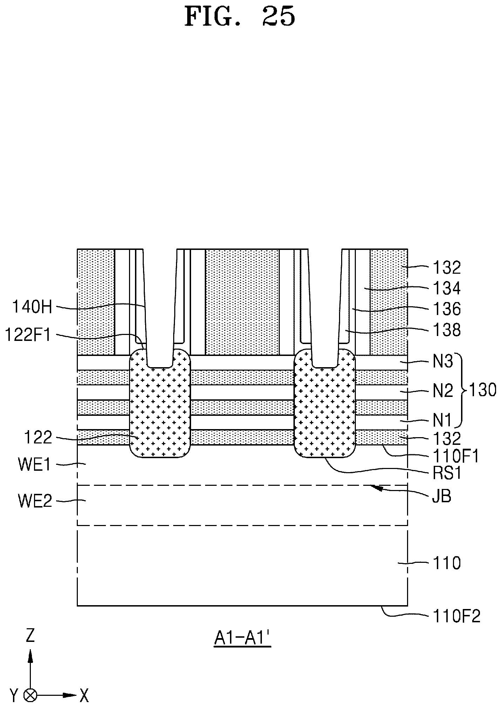

Referring to FIG. 25, a mask pattern may be formed on the first buried insulating layer 138, and by using the mask pattern as an etch mask, portions of the first buried insulating layer 138 and the etch stop film 136 may be removed to form a first contact hole 140H.

In embodiments of the present inventive concept, the first contact hole 140H may be formed to expose the first surface 122F1 of the upper semiconductor layer 122. For example, in an etching process for forming the first contact hole 140H, an upper portion of the upper semiconductor layer 122 may be removed.

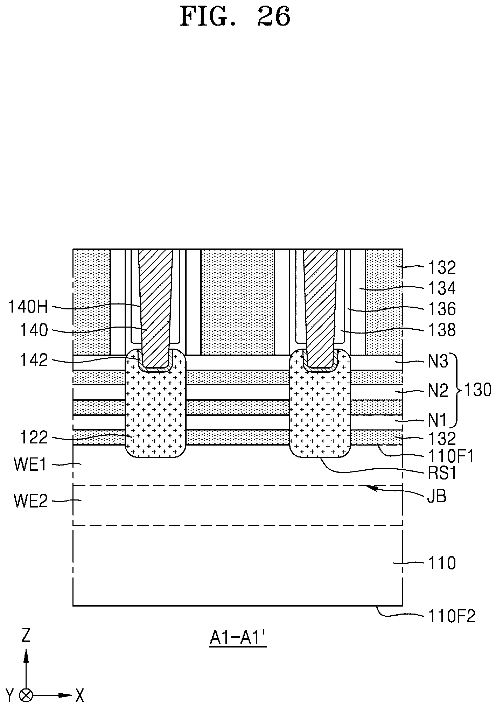

Referring to FIG. 26, the metal silicide film 142 may be formed in the first contact hole 140H and may be formed on the first surface 122F1 of the upper semiconductor layer 122, and the first surface 122F1 may be exposed by the first contact hole 140H. In embodiments of the present inventive concept, the metal silicide film 142 may include tungsten silicide, nickel silicide, and/or cobalt silicide.

Afterwards, the first contact 140 may be formed in the first contact hole 140H.

In embodiments of the present inventive concept, the first contact 140 may include a conductive barrier pattern and a contact plug, and the conductive barrier pattern may at least partially surround a bottom surface and sidewall of a contact plug and may be in contact with the bottom surface and sidewall of the contact plug. In embodiments of the present inventive concept, the conductive barrier pattern may include metal or metal nitride. For example, the conductive barrier pattern may include Ti, Ta, W, TiN, TaN, WN, WCN, TiSiN, TaSiN, WSiN, or a combination thereof, but the present inventive concept is not limited thereto. The contact plug may include, for example, molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but the present inventive concept is not limited thereto.

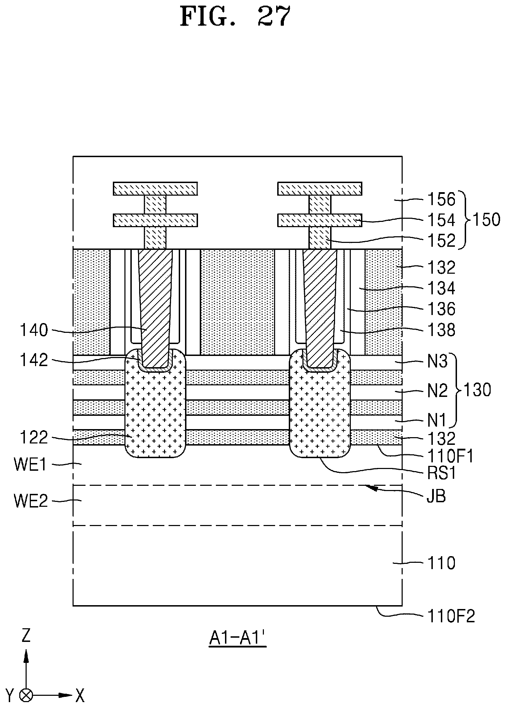

Referring to FIG. 27, the front-surface wiring structure 150 may be formed on the first buried insulating layer 138. The front-surface wiring structure 150 may include the front-surface via 152, the front-surface wiring layer 154, and the front-surface interlayer insulating film 156. The front-surface wiring structure 150 may be arranged to be electrically connected with the first contact 140. In addition, a portion of the front-surface wiring layer 154 may have a pad shape to apply a power voltage or a ground voltage to the upper semiconductor layer 122 via the first contact 140.

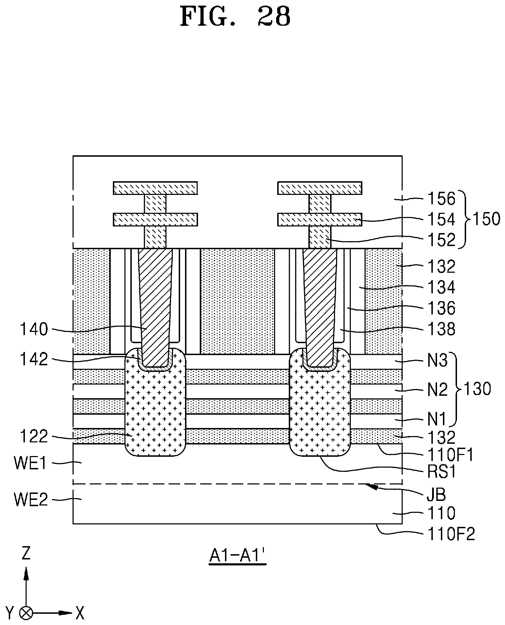

Referring to FIG. 28, the thickness of the substrate 110 may be reduced by performing a grinding process on the second surface 11 0F2 of the substrate 110.

In embodiments of the present inventive concept, the substrate 110 may be ground to a predetermined thickness such that the first well region WE1 is disposed in an upper side of the substrate 110 and the second well region WE2 is disposed in a lower side of the substrate 110, and thus, the first well region WE1 and the second well region WE2 are arranged to vertically overlap (or overlay) each other in the substrate 110. Accordingly, the second well region WE2 may be exposed at the second surface 110F2 of the substrate 110.

For convenience of description, FIG. 28 illustrates that the second surface 110F2 of the substrate 110 faces downward, but a process for grinding the substrate 110 may be performed in a state in which the second surface 110F2 of the substrate 110 is flipped to face upward.

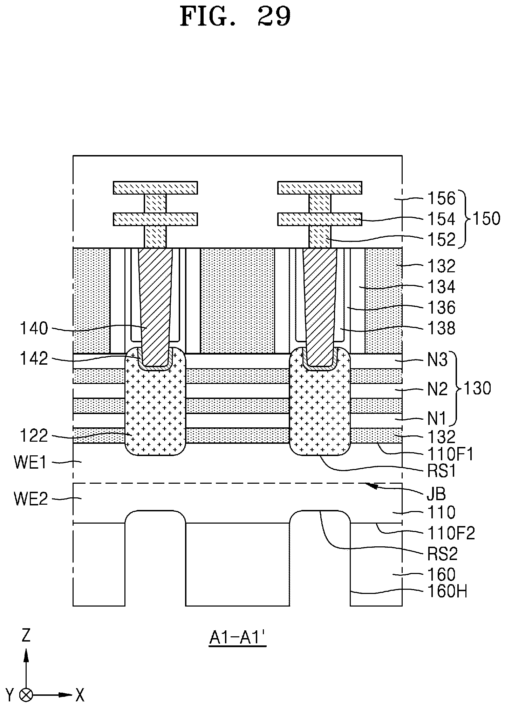

Referring to FIG. 29, the mold insulating layer 160 may be formed on the second surface 110F2 of the substrate 110. The mold insulating layer 160 may include a TEOS film, an HDP oxide film, a BPSG film, an FCVD oxide film, a SiON film, a SiN film, a SiOC film, or a SiCOH film.

Afterwards, a portion of the mold insulating layer 160 may be removed to form the opening 160H. The opening 160H may expose a portion of the second surface 110F2 of the substrate 110 which vertically overlaps (or overlays) the upper semiconductor layer 122. In a process for forming the opening 160H, a portion of the second surface 110F2 of the substrate 110 may be further removed to form the second recess region RS2, and the portion is exposed inside the opening 160H.

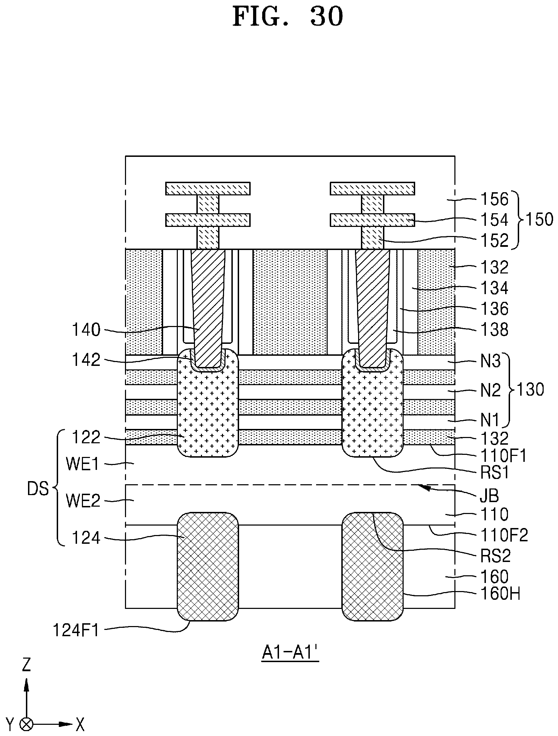

Referring to FIG. 30, the lower semiconductor layer 124 may be formed in the second recess region RS2. For example, the lower semiconductor layer 124 may be formed by epitaxially growing a semiconductor material from the second surface 110F2 of the substrate 110, and the second surface 110F2 is exposed to an inner wall of the second recess region RS2.

In embodiments of the present inventive concept, the lower semiconductor layer 124 may be formed by using at least one semiconductor material such as Si, SiGe, SiP, SiGeB, and/or SiGeC. In embodiments of the present inventive concept, during an epitaxy process for forming the lower semiconductor layer 124, a second dopant of a second conductivity type may be doped together. In addition, after the epitaxy process for forming the lower semiconductor layer 124, the second dopant may be ion planted. The lower semiconductor layer 124 may be a region including a relatively high concentration of the second dopant, and for example, may be referred to as a P+ region.

A first surface 124F1 of the lower semiconductor layer 124 may be arranged to protrude to the outside of the mold insulating layer 160. For example, the first surface 124F1 of the lower semiconductor layer 124 may refer to a surface of the lower semiconductor layer 124, and the surface may be arranged away from the second surface 110F2 of the substrate 110. In addition, the first surface 124F1 of the lower semiconductor layer 124 may refer to a bottom surface of the lower semiconductor layer 124 as shown in FIG. 30.

The upper semiconductor layer 122, the first well region WE1, the second well region WE2, and the lower semiconductor layer 124 are collectively referred to as the diode structure DS. The diode structure DS may be a vertical diode which extends from the first surface 110F1 of the substrate 110 to the second surface 110F2 of the substrate 110 and which may have a current path formed therein in the vertical direction Z via the diode structure DS.

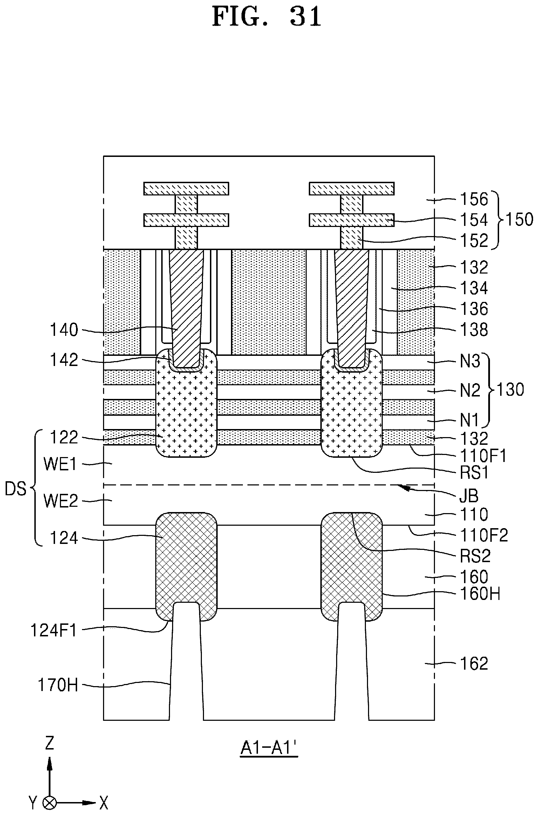

Referring to FIG. 31, the second buried insulating layer 162 may be formed on the mold insulating layer 160 to cover the first surface 124F1 of the lower semiconductor layer 124.

Afterwards, a portion of the second buried insulating layer 162 may be removed to form a second contact hole 170H. The second contact hole 170H may expose the first surface 124F1 of the lower semiconductor layer 124.

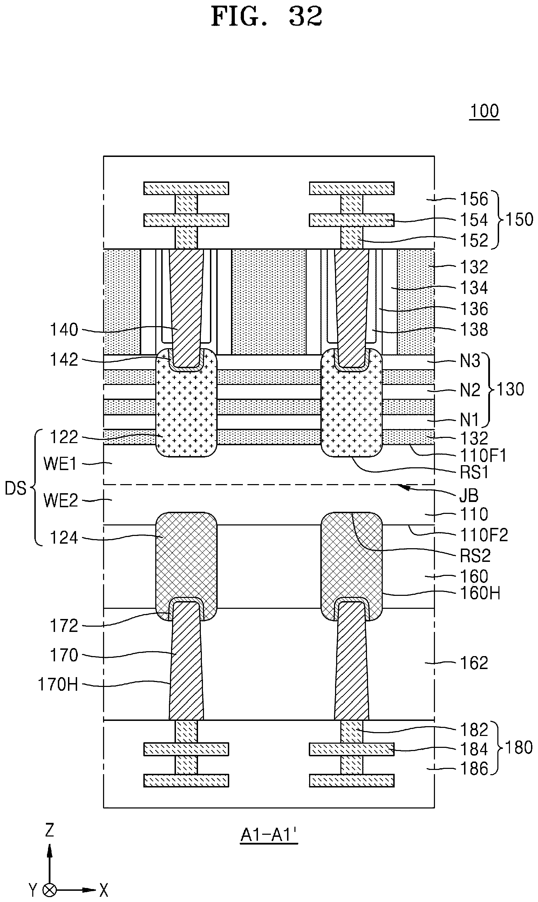

Referring to FIG. 32, the metal silicide film 172 may be formed in the second contact hole 170H and may be formed on the first surface 124F1 of the lower semiconductor layer 124, and the first surface 124F1 may be exposed by the second contact hole 170H. In embodiments of the present inventive concept, the metal silicide film 172 may include tungsten silicide, nickel silicide, or cobalt silicide.

Afterwards, the second contact 170 may be formed in the second contact hole 170H.

In embodiments of the present inventive concept, the second contact 170 may include a conductive barrier pattern and a contact plug, and the conductive barrier pattern may at least partially surround a bottom surface and sidewall of a contact plug and may be in contact with the bottom surface and sidewall of the contact plug.

Afterward, the rear-surface wiring structure 180 may be formed on the second buried insulating layer 162 and the second contact 170. The rear-surface wiring structure 180 may include the rear-surface via 182, the rear-surface wiring layer 184, and the rear-surface interlayer insulating film 186. The rear-surface wiring structure 180 may be arranged to be electrically connected with the second contact 170. In addition, a portion of the rear-surface wiring layer 184 may have a pad shape to apply a power voltage or a ground voltage to the lower semiconductor layer 124 via the second contact 170.

The integrated circuit device 100 may be formed by performing the above-described process.

While the present inventive concept has been described with reference to example embodiments thereof, it will be understood by those of ordinary skill in the art that various changes in form and details may be made thereto without departing from the scope of the present inventive concept.

## Claims

1. An integrated circuit device comprising:
a substrate comprising a first surface and a second surface that is opposite to the first surface; and
a diode structure comprising:
an upper semiconductor layer disposed on the first surface of the substrate and comprising a first dopant of a first conductivity type;
a lower semiconductor layer disposed on the second surface of the substrate and comprising a second dopant of a second conductivity type that is different from the first conductivity type; and
a first well region provided in a portion of the substrate that is between the upper semiconductor layer and the lower semiconductor layer, wherein the first well region is in contact with the upper semiconductor layer or the lower semiconductor layer.

2. The integrated circuit device of claim 1, wherein the first well region is in contact with the upper semiconductor layer and comprises a third dopant of the first conductivity type, and
the diode structure further comprises a second well region provided in a portion of the substrate that is between the upper semiconductor layer and the lower semiconductor layer, wherein the second well region is in contact with the lower semiconductor layer, and comprises a fourth dopant of the second conductivity type.

3. The integrated circuit device of claim 2, wherein the first well region is arranged in a first portion of the substrate that is adjacent to the first surface of the substrate,
wherein the second well region is arranged in a second portion of the substrate that is adjacent to the second surface of the substrate, and
wherein the first well region and the second well region overlap each other in a vertical direction that is substantially perpendicular to the first surface of the substrate.

4. The integrated circuit device of claim 2 or 3, wherein the upper semiconductor layer, the first well region, the second well region, and the lower semiconductor layer form a vertical diode.

5. The integrated circuit device of any preceding claim, wherein the upper semiconductor layer has a first width in a second horizontal direction that is parallel to the first surface of the substrate, and the first width of the upper semiconductor layer is greater than or equal to about 0.5 nm.

6. The integrated circuit device of any preceding claim, further comprising:
a first contact disposed on the upper semiconductor layer;
a front-surface wiring structure electrically connected to the first contact;
a second contact disposed on the lower semiconductor layer; and
a rear-surface wiring structure electrically connected to the second contact.

7. The integrated circuit device of any preceding claim, further comprising:
a nanosheet structure disposed on the first surface of the substrate and arranged adjacent to a sidewall of the upper semiconductor layer; and
a mold insulating layer disposed on the second surface of the substrate and at least partially surrounding a sidewall of the lower semiconductor layer,
wherein the nanosheet structure comprises at least two nanosheets that are spaced apart from each other in a vertical direction that is substantially perpendicular to the first surface of the substrate.

8. The integrated circuit device of claim 7, further comprising a cover insulating line at least partially surrounding the at least two nanosheets and contacting a portion of the sidewall of the upper semiconductor layer.

9. The integrated circuit device of claim 7, wherein a sidewall profile of the upper semiconductor layer is different from a sidewall profile of the lower semiconductor layer.

10. The integrated circuit device of claim 8 or 9, wherein the sidewall of the upper semiconductor layer comprises a first portion that is in contact with the nanosheet structure and a second portion that is in contact with the cover insulating line, and
the second portion of the sidewall of the upper semiconductor layer protrudes outward with respect to the first portion of the sidewall of the upper semiconductor layer.

11. The integrated circuit device of any of claims 7 to 10, further comprising:
a dummy gate line at least partially surrounding the at least two nanosheets and extending in a first horizontal direction that is parallel to the first surface of the substrate; and
a gate insulating layer arranged between the dummy gate line and the at least two nanosheets.

12. The integrated circuit device of any preceding claim, wherein the upper semiconductor layer has a first width in a second horizontal direction that is parallel to the first surface of the substrate, and
the lower semiconductor layer has a second width that is substantially the same as the first width in the second horizontal direction.

13. The integrated circuit device of any preceding claim, wherein the upper semiconductor layer has a first height in a vertical direction that is substantially perpendicular to the first surface of the substrate, and
the lower semiconductor layer has a second height that is different from the first height in the vertical direction.

14. The integrated circuit device of any preceding claim, wherein the first well region comprises an upper surface and a bottom surface,
the upper surface of the first well region is in contact with the upper semiconductor layer,
the bottom surface of the first well region is in contact with the lower semiconductor layer, and
the first well region comprises a fourth dopant of the second conductivity type.

15. An integrated circuit device comprising:
a diode structure, wherein the diode structure comprises:
an upper semiconductor layer disposed on a first surface of a substrate and comprising a first dopant of a first conductivity type;
a lower semiconductor layer disposed on a second surface of the substrate that is opposite to the first surface of the substrate and comprising a second dopant of a second conductivity type that is different from the first conductivity type;
a first well region arranged in a first portion of the substrate and comprising a third dopant of the first conductivity type, wherein the first portion is adjacent to the first surface of the substrate; and
a second well region arranged in a second portion of the substrate and comprising a fourth dopant of the second conductivity type, wherein the second portion is adjacent to the second surface of the substrate.
